# EUROPÄISCHE PATENTSCHRIFT

(11) **EP 3 507 652 B1**
(45) Veröffentlichungstag und Bekanntmachung des Hinweises auf die Patenterteilung: **21.10.2020**
(21) Anmeldenummer: 16770451.9
(22) Anmeldetag: 05.09.2016
(51) Int. Cl.: G03F 7/00

(54) **ANLAGE UND VERFAHREN ZUM PRÄGEN VON MIKRO- UND/ODER NANOSTRUKTUREN**
SYSTEM AND METHOD FOR EMBOSSING MICRO-AND/OR NANO-STRUCTURES
INSTALLATION ET PROCÉDÉ POUR IMPRIMER DES MICRO- ET/OU NANOSTRUCTURES

(43) Veröffentlichungstag der Anmeldung: 10.07.2019
(60) Teilanmeldung: 20190255.8
(73) Patentinhaber: EV Group E. Thallner GmbH, 4782 St. Florian am Inn (AT)
(72) Erfinder: LINDNER, Friedrich Paul, 4780 St. Florian am Inn (AT); ZAGLMAYR, Harald, 4840 Vöcklabruck (AT); SCHÖN, Christian, 4770 Andorf (AT); GLINSNER, Thomas, 4782 St. Florian am Inn (AT); REISINGER, Evelyn, 4776 Diersbach (AT); FISCHER, Peter, 4775 Taufkirchen an der Pram (AT); LUKSCH, Othmar, 4782 St. Florian am Inn (AT)
(74) Vertreter: Schneider, Sascha
(86) Internationale Anmeldenummer: PCT/EP2016/070837
(87) Internationale Veröffentlichungsnummer: WO 2018/041371

(56) Entgegenhaltungen:
- EP-A1- 2 058 107
- WO-A1-2016/045961
- US-A1- 2009 045 539
- US-A1- 2011 266 709
- US-A1- 2016 031 151

## Beschreibung

Die Erfindung betrifft eine Anlage und ein Verfahren zum Prägen von Mikro-und/oder Nanostrukturen.

Die Druckschrift WO 2016/045961 A1 offenbart eine Vorrichtung zum Prägen von Nanostrukturen in ein Prägematerial. Druckschrift US 2009/045539 A1 offenbart eine Prägevorrichtung, bei der eine Prägeform über eine Halterung mit einem beweglichen Element verbunden ist. Druckschrift US 2011/266709 A1 offenbart eine Vorrichtung mit einer Prägeform, die aus einem Stempelteil und einem Präger gebildet ist. Druckschrift EP 2058107 A1 offenbart eine Prägevorrichtung, bei der auf einem Stempel mittels Aktuatoren Kräfte einstellbar sind. Druckschrift US 2016/031151 A1 offenbart eine Nanoimprintanlage mit einem beweglichen Kopf.

Im Stand der Technik werden Mikro- und/oder Nanostrukturen entweder photolithographisch und/oder mit Hilfe der Imprintlithographie hergestellt. Unter der Imprintlithographie versteht man ein Verfahren, bei dem Mikro-und/oder Nanometer große Strukturen durch einen Stempel in ein Material geprägt werden. Bei dem Material handelt es sich um ein auf ein Substrat aufgebrachtes Prägematerial. Derartige Imprintverfahren haben in den letzten Jahren zunehmend an Bedeutung gewonnen, da sie schneller, effektiver und kostengünstiger durchzuführen sind als viele photolithographischen Verfahren. Des Weiteren hat sich gezeigt, dass die erreichbare Auflösung mittels imprintlithographischer Verfahren der Auflösung, die man mit Hilfe der Photolithographie erzielen kann, um nichts nachsteht.

Die verwendeten Anlagen im Stand der Technik weisen mehrere Nachteile auf. Die Anlagen sind auf eine Größe ausgelegt, die ein Prozessieren von Substraten oberhalb eines gewissen Durchmessers, insbesondere von mehr als 300mm, nicht oder nur schwer erlaubt. Man kann grundsätzlich zwei unterschiedliche Arten von Imprintanlagen im Stand-der-Technik ausmachen.

Die meisten Ausführungsformen werden in sogenannte Maskenausrichter (engl.: Mask Aligner) eingebaut oder als eigenständige Anlage konzipiert, die aber keine Substrate größer als 300 mm prozessieren können. Besonders Mask Aligner eignen sich für spezielle Imprintanlagen, da sie in der Halbleiterindustrie bereits weite Verbreitung für die Photolithographie erfahren haben. Dadurch wurde es für Anbieter zweckmäßig, Erweiterungen und Aufsätze anzubieten, die auf bereits bekannter Mask Aligner Technologie aufbauten oder diese erweitern konnten. Der Vorteil von Mask Alignern besteht vor allem darin, dass sie in den meisten Fällen bereits über optische Systeme, insbesondere Lampenhäuser zur, insbesondere vollflächigen, Beleuchtung der Substrate und damit der geprägten Prägematerialien bieten.

Neben modifizierten bzw. erweiterten Mask Alignern existieren auch eigene Imprintanlagen, die auf und für spezielle Ausführungsformen gebaut wurden. Diese Anlagen sind meistens hoch präzise Ausrichtungsanlagen, die einen Stempel mit noch höherer Präzision zum Substrat ausrichten können. Des Weiteren verfügen diese Anlagen über die Möglichkeit zur Erzeugung von Vakuum, spezielle Dispenssystem etc. Derartige Imprintanlagen weisen auch nur selten die Möglichkeit auf, ein Prägematerial auf einem Substrat von mehr als 300 mm zu prägen.

Aus den genannten Umständen ergibt sich das Problem, dass das Prägen von großflächigen, insbesondere rechteckigen, Substraten wie sie beispielsweise für Flachbildschirmherstellung benötigt werden, nicht oder nur sehr schwer durchführbar ist. Manchmal soll eine Struktur sogar auf Substrate mit einer solchen Größe geprägt werden, dass aus dem Substrat mehrere einzelne Großbildschirmteile entstehen. Dadurch würde erfindungsgemäß eine extreme Durchsatzsteigerung folgen, die sich positiv auf die Kosten auswirken würde.

Außerdem besteht noch das Problem, die geprägten Flächen entsprechend zu beleuchten. Die Beleuchtungsanlagen müssten extrem groß ausgelegt werden, was zu einer technisch nicht realisierbaren Anlage führen würde.

Ein weiteres Problem besteht in der Ablösung des sehr großen Stempels von den großen Flächen. Die Stempelablösung muss hochpräzise gesteuert und kontrolliert werden und vor allem so erfolgen, dass die geprägte Struktur und der Stempel bei der Entformung des Stempels keinen Schaden nehmen.

Der heutige Stand der Technik für die Mikro- und/oder Nanostrukturierung von Oberflächen umfasst vor allem die Photolithographie und die unterschiedlichen Prägetechniken. Die Prägetechniken arbeiten entweder mit harten oder weichen Stempeln. In letzter Zeit setzen sich vor allem die Prägelithographietechniken durch und verdrängen die klassischen Photolithographietechniken. Unter den Prägelithographietechniken wird vor allem die Verwendung von sogenannten weichen Stempeln immer beliebter. Der Grund liegt in der leichten Herstellung der Stempel, effizienten Prägevorgängen, sehr guten Oberflächeneigenschaften der jeweiligen Stempelmaterialien, den geringen Kosten, der Reproduzierbarkeit des Prägeproduktes und vor allem in der Möglichkeit der elastischen Verformung des Stempels während dem Prägen und der Entformung. In der Softlithographie wird ein Stempel aus einem Elastomer mit einer mikro- bzw. nanostrukturierten Oberfläche verwendet, um Strukturen im Bereich von 20 nm bis >1000 µm herzustellen.

Es gibt sechs bekannte Techniken:
- Mikro- und/oder Nanokontaktdrucken (µ/nCP)
- Replikagießen (REM)
- Microtransfer moulding (µTM) oder nanoimprint lithographie (NIL),
- Mikroformung in Kapillaren (MIMIC)
- lösungsmittelunterstützten Mikroformen(SAMIM) und
- Phaseshift Lithographie.

Elastomere Stempel werden als Negativ eines Masters hergestellt. Beim Masterstempel handelt es sich um einen Hartstempel aus Metall, Kunststoff und/oder Keramik, der durch entsprechend aufwendige Prozesse einmal hergestellt wird. Aus dem Master können dann beliebig viele elastomere Stempel hergestellt werden. Die elastomeren Stempel ermöglichen einen konformen, gleichmäßigen Kontakt über große Oberflächen. Sie sind leicht von ihrem Masterstempel, sowie von den Prägeprodukten zu trennen. Weiterhin haben elastomere Stempel eine geringe Oberflächenenergie für eine leichte und einfache Trennung von Stempel und Substrat. Zur automatisierten Realisierung von soft lithographischen Prozessen ist es nötig, den elastomeren Stempel durch einen Träger zu unterstützen. Derzeit werden Glasträgersubstrate mit verschiedenen Dicken verwendet. Durch die Verwendung dicker Glassubstrate verliert der elastomere Stempel allerdings, zumindest teilweise, seine Flexibilität.

Ein Master kann insbesondere durch einen step-and-repeat Prozess (S&R Prozess) hergestellt werden. Das ist vor allem dann vorteilhaft, wenn man sehr große Master herstellen muss. Der Master wird dabei durch einen weiteren, Master-Master, hergestellt. In der Fachsprache nennt man allerdings den Master, von dem die Weichstempel abgeformt werden meistens Sub-Master und den Master zur Herstellung des Sub-Masters Master. Die Definitionen können variieren. Es wird allerdings offenbart, dass ein, insbesondere großflächiger, Master (bzw. Sub-Master), der zur Abformung von Weichstempeln verwendet wird, durch einen wiederholten Prägeprozess (step-and-repeat Prozess) hergestellt werden kann, der sich dadurch auszeichnet, dass an einer ersten Stelle geprägt, danach der Master-Master (bzw. Master) verfahren und danach mindestens ein weiteres Mal geprägt wird.

Des Weiteren ist denkbar, dass ein Master in einem step-and-repeat Prozess verwendet wird, um direkt den elastomeren Stempel zu prägen. Das ist vor allem dann vorteilhaft, wenn der elastomere Stempel sehr groß ist. Der Master wird dabei an eine erste Position verfahren, prägt dort den elastomeren Stempel, verfährt dann zu einer zweiten, von der ersten Position unterschiedlichen, Position und prägt erneut. Dieser Prozess kann so oft fortgesetzt werden, bis ein elastomerer Stempel beliebiger Größe erzeugt wurde.

Die Verwendung von starren Trägern erschwert im Allgemeinen das automatische Trennen von Stempel und Substrat nach dem Prägeprozess, wodurch eine Prozessautomatisierung und eine industrielle Verwertbarkeit der Imprintlithographie nur schwer möglich sind.

Ein weiteres allgemeines Problem von Stempeln besteht darin, dass sie meistens nur eine begrenzte Größe besitzen. Dadurch wird es nicht ohne weiteres möglich, große Flächen zu prägen. Eine Möglichkeit einer kontinuierlichen Prägung stellen Rollenstempel dar, die hier aber nicht weiter behandelt werden sollen. Für die Prägung von mikro- und/oder nanometergroßen Strukturen auf großen Substraten, insbesondere Platten, existieren im Stand der Technik nur sehr wenige und vor allem keine ausgereiften Anlagen oder Methoden.

Es ist daher die Aufgabe der Erfindung, eine verbesserte Anlage und ein verbessertes Verfahren zum Prägen von Mikro- und/oder Nanostrukturen anzugeben, die die Nachteile des Stands der Technik nicht mehr aufweisen und mit denen insbesondere eine Automatisierung und eine schnellere Prozessierung von großflächigen Substraten gewährleistet werden kann.

Diese Aufgabe wird mit dem Gegenstand der nebengeordneten Patentansprüche gelöst. Vorteilhafte Weiterbildungen der Erfindung sind in den Unteransprüchen angegeben. In Rahmen der Erfindung fallen auch sämtliche Kombinationen aus zumindest zwei von in der Beschreibung und/oder den Figuren angegebenen Merkmalen, sofern sie im Schutzumfang der Ansprüche enthalten sind. Den angegebenen Wertebereichen sollen auch innerhalb der genannten Grenzen liegende Werte als Grenzwerte offenbart und in beliebiger Kombination beanspruchbar sein.

Die Erfindung betrifft eine Anlage zum Prägen von Mikro- und/oder Nanostrukturen mit einem Modul, wobei das Modul einen Strukturstempel und mindestens ein bewegliches Prägeelement aufweist, wobei das Modul vorzugsweise ein dem Prägeelement nachfahrbares Lampenhaus aufweisen kann.

Das Lampenhaus bewegt sich, insbesondere parallel zur Substratoberfläche, mit einer Geschwindigkeit zwischen 1 mm/s und 1000 mm/s, vorzugsweise zwischen 5 mm/s und 750 mm/s, noch bevorzugter zwischen 7.5 mm/s und 500 mm/s, am bevorzugtesten zwischen 10 mm/s und 250 mm/s, am allerbevorzugtesten mit 100 mm/s.

Außerdem betrifft die Erfindung ein Verfahren zum Prägen von Mikro- und/oder Nanostrukturen auf ein Substrat, wobei ein bewegliches Prägeelement durch Krafteinwirkung auf einen Strukturstempel die Mikro- und/oder Nanostrukturen auf das Substrat prägt, wobei vorzugsweise ein Lampenhaus dem Prägeelement nachfahren kann.

Das Prägeelement bewegt sich, insbesondere parallel zur Substratoberfläche, mit einer Geschwindigkeit zwischen 1 mm/s und 1000 mm/s, vorzugsweise zwischen 5 mm/s und 750 mm/s, noch bevorzugter zwischen 7.5 mm/s und 500 mm/s, am bevorzugtesten zwischen 10 mm/s und 250 mm/s, am allerbevorzugtesten mit 100 mm/s. Insbesondere bewegen sich Prägeelement und Lampenhaus mit derselben Geschwindigkeit.

Als Prägeelement bzw. Prägeelemente kann bzw. können alle Bauteile oder Bauteilgruppen verwendet werden, mit deren Hilfe man in der Lage ist, eine, im allgemeinen inhomogene, also als Funktion des Ortes nicht konstante, vorzugsweise aber homogene, also als Funktion des Ortes konstante, Linien-und/oder Flächenkraft auf den Strukturstempel auszuüben.

Im weiteren Verlauf der Druckschrift wird nur mehr von einer Linienkraft gesprochen werden. Es soll aber stets auch die Flächenkraft umfasst sein.

Durch das Prägeelement bzw. die Prägeelemente kann der Strukturstempel einerseits in die Prägemasse gedrückt werden. Andererseits kann mit Hilfe des Prägeelements der Entformungsprozess des Strukturstempels aus der Prägemasse gezielt gesteuert und kontrolliert werden.

Als Prägeelement bzw. Prägeelemente kommen vor allem in Frage:
- Festkörper, insbesondere
   o Rollen
   o Schneiden
   o Klingen
- Fluidstrahlen, insbesondere
   o Druckluft

Im weiteren Verlauf der Druckschrift wird das Prägeelement beispielhaft vor allem als Rolle beschrieben und dargestellt werden.

Außerdem betrifft die Erfindung die Verwendung der erfindungsgemäßen Anlage zum Prägen von Mikro- und/oder Nanostrukturen auf ein Substrat.

Weiterhin betrifft die Erfindung, insbesondere als eigenständigen Aspekt, ein Stempelsystem, aufweisend einen Strukturstempel (im Folgenden auch einfach nur Stempel genannt), insbesondere einen Weichstempel, zum Prägen von Mikro- und/oder Nanostrukturen und einen mit dem Stempel, insbesondere flächig, verbundenen Träger, insbesondere aus Glas, wobei der Stempel und der optionale Träger derart elastisch ausgebildet sind, dass sie durch ein Prägeelement verformbar sind. Der Träger und der optionale Stempel werden insbesondere über eine adhäsive Schicht miteinander verbunden.

Weiterhin betrifft die Erfindung, insbesondere als eigenständigen Aspekt, Entformungsmittel zum Trennen eines Strukturstempels von einem Prägematerial für eine erfindungsgemäße Anlage Bei den Entformungsmitteln handelt es sich um eine Bauteilgruppe. Das erste Bauteil der Bauteilgruppe ist das Prägeelement, mit dessen Hilfe das Abziehen des Strukturstempels von der Prägemasse gezielt gesteuert werden kann. Das zweite Bauteil ist das Prägeelementaufhängungssystem, mit dem das Prägeelement gesteuert werden kann. Das dritte Bauteil der Bauteilgruppe ist eine Spannleiste, mit der der Strukturstempel fixiert werden kann. Das vierte Bauteil der Bauteilgruppe ist ein Hebesystem für die Spannleiste, welches die Spannleiste entlang der Z-Richtung bewegen kann, während es selbst in einer zweiten Richtung, insbesondere zur Z-Richtung normalen Richtung, verfahren werden kann.

Weiterhin betrifft die Erfindung, insbesondere als eigenständigen Aspekt, ein Prägeelementaufhängungssystem (im Folgenden auch Prägeelementaufhängungseinrichtung genannt) zur Aufhängung eines Prägeelements einer, insbesondere erfindungsgemäßen, Anlage, derart ausgebildet, dass eine auf einen Strukturstempel und/oder einen Träger des Strukturstempels wirkende Kraft durch eine Gegenkraft gezielt einstellbar ist. Im Falle der Verwendung von Düsen zur Kraftbeaufschlagung des Strukturstempels mit Hilfe eines Fluids, handelt es sich bei dem Prägeelementaufhängungssystem um alle Bauteile, welche der gezielten Fluidsteuerung dienen. Insbesondere versteht man darunter eine Düse, insbesondere eine Düse, welche ein Gas entlang einer Line unter regelbarem Druck ausströmen lassen kann.

Weiterhin betrifft die Erfindung, insbesondere als eigenständigen Aspekt, eine Prägeelementaufhängungseinrichtung zur Aufhängung eines Prägeelements einer, insbesondere erfindungsgemäßen, Anlage, derart ausgebildet, dass die Kraft des Prägeelements auf den Strukturstempel nicht nur gleichmäßig, sondern unsymmetrisch aufgebracht werden kann. Dies wird sehr einfach dadurch bewerkstelligt, dass das Prägeelement über die Prägeelementaufhängungseinrichtung links und/oder rechtsseitig mit unterschiedlich steuerbaren Kräften beaufschlagbar ist. Dadurch wird während der Prägung und/oder der Entformungsunterstützung durch das Prägeelement eine gezielte Kontrolle der Kraft, die auf den Strukturstempel wirkt, ermöglicht.

Des Weiteren beschreibt die Erfindung insbesondere eine Anlage und ein Verfahren zur gesteuerten, hochpräzisen, fehlerfreien Entformung des Strukturstempels von der Prägefläche, insbesondere durch eine kombinierte Anwendung der Entformungselemente.

Bevorzugt ist vorgesehen, dass mit einer translatorischen Bewegung des Prägeelements eine Nachrückung des Lampenhauses erfolgt. Die Nachrückung kann dabei entweder gleichzeitig, daher synchron, mit der Bewegung des Prägeelements oder zeitverzögert erfolgen. Erfindungsgemäß von Bedeutung ist, dass das Lampenhaus immer nur einen Teilabschnitt von dem Prägematerial belichtet. Durch diese erfindungsgemäße Ausführungsform ist vorteilhaft eine Beschränkung der Größe des Lampenhauses, insbesondere der Lichtquelle, möglich. Sollte ein nachfahrendes Lampenhaus nicht zweckdienlich sein, kann der gesamte Strukturstempel, und damit die Prägemasse, mit einer entsprechend großen Lichtquelle oder einem entsprechenden optischen System, vollflächig beleuchtet werden.

Der Stempel wird vorzugsweise auf einem Träger (engl.: backplane), insbesondere einer Platte, am bevorzugtesten einem Glasträger, fixiert. Weitere denkbare Materialien für den Träger sind Polymere und/oder Metalle. Die Polymere werden vorzugsweise als Kunststofffolien und/oder dünne Kunststoffplatten, die Metalle vorzugsweise als Metallfolien und/oder dünne Metallbleche eingesetzt. Der Träger besitzt eine Dicke zwischen 10 µm und 1000 µm, vorzugsweise zwischen 50 µm und 800 µm, noch bevorzugter zwischen 100 µm und 600 µm, am bevorzugtesten zwischen 150 µm und 400 µm, am allerbevorzugtesten um die 200 µm.

Der Stempel wird auf einer Beaufschlagungsseite erfindungsgemäß entlang seiner gesamten Länge, insbesondere in einem kontinuierlichen Prozess, mit einer, insbesondere sich quer zur Länge erstreckenden, insbesondere entlang der gesamten Länge homogenen, Linienkraft beaufschlagt, um die Strukturen in das Prägematerial (im Folgenden auch Prägemasse genannt) zu drücken. Mit Vorzug erfolgt die Beaufschlagung mit Hilfe eines Prägeelements, insbesondere einer, vorzugsweise starren, Prägerolle. Der entsprechende Aufbau ist grundsätzlich bereits aus der Druckschrift WO 2014037044 A1 bekannt. Der erfindungsgemäße Aspekt der vorliegenden Erfindung besteht insbesondere in der Beschreibung einer Anlage und eines Verfahrens, bei dem die in der Druckschrift WO 2014037044 A1 erwähnte Ausführungsform für die großflächige Prägung verwendet werden kann. Erfindungsgemäß wird dabei aber auf den in der Druckschrift WO 2014037044 A1 erwähnten Rahmen verzichtet, um den Strukturstempel abziehen zu können.

In einer Weiterführung der erfindungsgemäßen Ausführungsform kann die Linienkraft auch inhomogen sein. Eine inhomogene Linienkraft kann insbesondere dadurch erreicht werden, dass das Prägeelement an seinem linke Aufhängungspunkt mit einer Kraft beaufschlagt wird, welche unterschiedlich ist zu der Kraft im rechten Aufhängungspunkt. Durch die Möglichkeit der Erzeugung einer inhomogenen Linienkraft können beispielsweise Strukturstempel mit einer höheren Dichte an Nanostrukturen an der rechten Seite, dort auch höher belastet werden, um eine homogene Prägung des gesamten Prägematerials zu gewährleisten

Unter einem Stempel wird im weiteren Verlauf jede Art von Bauteil verstanden, welches entsprechende Strukturelemente an seiner Oberfläche besitzt und die erfindungsgemäße Flexibilität beim Prägeprozess aufweist. Es kann sich bei einem Stempel um ein einzelnes oder um ein zusammengesetztes Bauteil handeln. Ist der Stempel nur als einzelnes Bauteil ausgeführt, so besteht der Stempel aus einer Folie oder einer flexiblen Platte, in welcher die entsprechenden Strukturelemente erzeugt worden sind. Im Falle eines zusammengesetzten Stempels, also einem Stempelsystem, besteht dieses aus einem Träger und einem entsprechenden, die Strukturelemente aufweisenden, Stempelbauteil. Träger und/oder Stempelbauteil müssen in diesem Fall als Bauteilgruppe die nötige Flexibilität aufweisen, um vom Prägeelement entsprechend verformt werden zu können. Der Träger besteht insbesondere aus einem der folgenden Materialien.
- Halbleiter
   o Ge, Si, Alpha-Sn, B, Se, Te
- Metall
   o Cu, Ag, Au, Al, Fe, Ni, Co, Pt, W, Cr, Pb, Ti, Ta, Zn, Sn
- Verbindungshalbleiter
   o GaAs, GaN, InP, InxGa1-xN ,InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGa1-xAs, GaS, GaSe, GaTe, InS, InSe, InTe, CuInSe2, CuInS2, CuInGaS2, SiC, SiGe
- Glas
   o Metallische Gläser
   o Nichtmetallische Gläser, insbesondere
      ▪ Organische nichtmetallische Gläser
      ▪ Anorganische nichtmetallische Gläser, insbesondere
         • Nichtoxidische Gläser, insbesondere
            o Halogenidgläser
            o Chalkogenidgläser
         • Oxidische Gläser, insbesondere
            o Phosphatische Gläser
            o Silikatische Gläser, insbesondere
               ▪ Alumosilikatgläser
               ▪ Bleisilikatgläser
               ▪ Alkali-Silikatgläser, insbesondere
                  • Alkali-Erdalkalisilikatgläser
               ▪ Borosilikatgläser
            o Boratgläser, insbesondere
               ▪ Alkaliboratgläser
- Kunststoffe, insbesondere
   o Elastomere, insbesondere
   ▪ Viton (Werkstoff) und/oder
   ▪ Polyurethane und/oder
   ▪ Hypalon (Werkstoff) und/oder
   ▪ Isopren-Kautschuk (Werkstoff) und/oder
   ▪ Nitril-Kautschuk (Werkstoff) und/oder
   ▪ Perfluorokautschuk (Werkstoff) und/oder
   ▪ Polyisobuten (Werkstoff) und/oder
   ▪ Polyethylenterephthalat (PET) und/oder
   ▪ Polycarbonat (PC) und/oder
   ▪ Polymethylmethacrylat (PMMA) und/oder
   ▪ Kapton

Eine Linienkraft gemäß der vorliegenden Erfindung bedeutet, dass die Kraftbeaufschlagung zwar in einer ersten Richtung, insbesondere quer zur Bewegung eines Prägeelements entlang des Stempels, zumindest überwiegend, insbesondere vollständig, erfolgt (also beispielsweise die gesamte wirksame Breite des Stempels erfasst), während in einer zweiten Richtung (insbesondere quer zur ersten Richtung) nur ein vergleichsweise sehr kleiner Bereich (insbesondere im Verhältnis 1 zu 5, vorzugsweise 1 zu 10, noch bevorzugter 1 zu 20, noch bevorzugter 1 zu 100 zur ersten Richtung) gleichzeitig beaufschlagt wird. Somit ergibt sich eine vergleichsweise kleine Beaufschlagungsfläche im Verhältnis zur Gesamtfläche des Stempels, die gleichzeitig beaufschlagt wird. Hierdurch wird nicht nur eine sehr definierte Beaufschlagung ermöglicht, sondern auch eine sehr homogene Prägung erreicht. Bei einer inhomogenen Verteilung von Strukturelementen auf dem Stempel kann für eine homogene Prägung vor allem eine inhomogene Linienkraft notwendig sein.

Der Stempel, sowie alle notwendigen Teile zur Durchführung eines erfindungsgemäßen Prozesses werden im weiteren Text als Modul bezeichnet. Zum Modul gehören insbesondere der Stempel, das Prägeelement mit dem Prägeelementaufhängungssystem, das Lampenhaus und die Entformungsmittel.

Eine erste erfindungsgemäße Ausführungsform besteht darin, große Substrate zu prägen, deren Durchmesser aber noch in der Größenordnung des Stempels liegt. Der Folienstempel kann daher noch ein Substrat in einem einzigen, vollständigen Schritt prägen ohne durch einen Step-and-Repeat Prozess an einer weiteren Position abgesetzt werden zu müssen. Die Substrate sind aber bereits so groß, dass die Verwendung eines, die Prägemasse auf dem Substrat vollflächig beleuchtendes, Lampenhauses nicht oder nur sehr schwer möglich ist. Das Lampenhaus wird daher vorzugsweise derart modifiziert, dass es kleine Teilsegmente der Prägemasse, insbesondere rechteckige Teilabschnitte, schrittweise bzw. kontinuierlich, belichten kann. Ein erfindungsgemäßer Gedanke besteht insbesondere darin, das Lampenhaus über die bereits geprägten Flächenabschnitte der Prägemasse zu bewegen. Der Vollständigkeit halber wird erwähnt, dass eine vollflächige Beleuchtung zwar aufwendig, teuer und extrem kompliziert, aber dennoch möglich ist.

Die Anlage bzw. das Verfahren kann optional im step-and-repeat-Betrieb betrieben bzw. durchgeführt werden. Ein optionaler Aspekt der Erfindung besteht insbesondere in der Möglichkeit, das Modul in einem Step-and-Repeat Prozess über sehr große Flächen zu bewegen und damit Flächen von mehreren Quadratmetern prägen zu können, indem der erfindungsgemäße Stempelprozess an jeder einzelnen Step-and-Repeat Position durchgeführt wird. Die Erfindung erlaubt somit außerdem eine großflächige Anwendung des Prägeverfahrens, insbesondere mit einer Breite größer als 0.01 m, vorzugsweise größer 1.0 m, noch bevorzugter größer 10 m und/oder einer Länge größer als 0.01 m, vorzugsweise größer 5 m, noch bevorzugter größer 10 m.

Ein weiterer optionaler Aspekt ist die Verwendung des Moduls an mindestens einer Seite eines Endlossubstrates. Unter einem Endlossubstrat versteht man ein, insbesondere auf einer ersten Rolle, gespeichertes Substrat, dessen Länge um ein vielfaches größer ist als seine Breite. Bei einem Endlossubstrat handelt es sich insbesondere um eine Endlosfolie. Das Endlossubstrat kann auch aus Glas geformt sein, wenn das Glas dünn genug ist, um gebogen zu werden ohne zu brechen. Typische Glasdicken liegen unter 1000 µm, vorzugsweise unter 500 µm, noch bevorzugter unter 250 µm, am bevorzugtesten um die 100 µm.

Durch unterschiedliche Prozesse, insbesondere Wärmebehandlungen, Härtungsprozesse etc. kann das Glas, insbesondere dessen Oberfläche, so modifiziert werden, dass es aufgerollt werden kann. Erfindungsgemäß kann das Modul dazu verwendet werden, auf einen Teil des Endlossubtrates einen erfindungsgemäßen Prägevorgang durchzuführen. Danach wird das Modul, insbesondere der Stempel, von dem Endlossubstrat entfernt und das Endlossubstrat bewegt sich eine gewünschte Einheit, insbesondere mindestens die Länge der geprägten Struktur, weiter. Danach kann erfindungsgemäß ein weiterer Prägevorgang stattfinden. Durch diese spezielle Ausführungsform bewegt sich das Modul vorzugsweise nur in die Normalenrichtung zum Endlossubstrat, während sich das Endlossubtrat schrittweise weiterbewegt. Das Endlossubstrat wird vorzugsweise in einem Speicher, insbesondere einer zweiten Rolle, gespeichert.

Der erfindungsgemäße Strukturstempel wird weitergebildet, indem der Stempel mittels zwei an den zwei gegenüberliegenden Spannseiten angeordneten Spannleisten gespannt wird. Die Spannleisten umfassen insbesondere Fixiermittel zur Fixierung des Stempels. Jede Spannleiste kann entweder direkt oder über ein Federsystem mit dem Stempel fixiert sein. Mit Vorzug wird allerdings mindestens eine der Spannleisten mittels Federn mit dem Stempel befestigt.

Die Prägerolle kann insbesondere über einen Motor verfügen, der die aktive Drehung der Prägerolle gestattet. Denkbar ist auch, dass die Prägerolle über ein Getriebe von einem externen Motor kontrolliert gedreht werden kann.

Die Translationsgeschwindigkeit der Prägerolle liegt zwischen 0.1 mm/s und 1000 mm/s, vorzugsweise zwischen 1.0 mm/s und 750 mm/s, noch bevorzugter zwischen 10 mm/s und 500 mm/s, am bevorzugtesten zwischen 75 mm/s und 250 mm/s, am allerbevorzugtesten um die 100 mm/s.

In Weiterbildung der vorliegenden Erfindung ist es vorgesehen, dass der Stempel aus einem Träger und einem hierauf gemoldeten oder heißgeprägten, insbesondere elastomeren, Stempel gebildet ist. Hierdurch wird die Herstellung des Strukturstempels günstiger.

Der elastomere Stempel besteht insbesondere aus einem der folgenden
- Polydimethylsiloxan (PDMS)
- Perfluoropolyether (PFPE)
- Polyhedrales oligomerisches Silsesquioxan (POSS)
- Polydimethylsiloxan (PDMS)
- Tetraethylorthosilicat (TEOS)
- Poly(organo)siloxane (Silikon)

Denkbar wäre auch die Verwendung eines der folgenden Materialien
- Acrylester-Styrol-Acrylnitril
- Acrylnitril/ Methylmethacrylat
- Acrylnitril/Butadien/Acrylat
- Acrylnitril/chloriertes Polyethylen/Styrol
- Acrylnitril-Butadien-Styrol
- Acrylpolymere
- Alkydharze
- Butadien-Kautschuk
- Butylkautschuk
- Casein-Kunststoffe, Kunsthorn
- Celluloseacetat
- Celluloseether und Derivate
- Cellulosehydrat
- Cellulosenitrat
- Chitin, Chitosan
- Chloropren-Kautschuk
- Cyclo-Olefin-Copolymere
- Einheitliches Polyvinylchlorid
- Epoxidharz
- Ethylen-Ethylacrylat- Copolymer
- Ethylen-Polyvinylacetat
- Ethylen-Propylen-Copolymer
- Ethylen-Propylen-Dien- Kautschuk
- Ethylenvinylacetat
- Expandierbares Polystyrol
- Fluorkautschuk
- Harnstoff-Formaldehydharz
- Harnstoffharze
- Isopren-Kautschuk
- Lignin
- Melamin-Formaldehydharz
- Melaminharze
- Methylacrylat/Butadien/ Styrol
- Naturkautschuk
- Perfluoralkoxylalkan
- Phenol-Formaldehydharz
- Polyacetale
- Polyacrylnitril
- Polyamid
- Polybutylensuccinat
- Polybutylenterephthalat
- Polycaprolacton
- Polycarbonat
- Polycarbonate
- Polychlortrifluorethylen
- Polyester
- Polyesteramid
- Polyetheralkohole
- Polyether-Block-Amid
- Polyetherimid
- Polyetherketone
- Polyethersulfon
- Polyethylen
- Polyethylenterephthalat
- Polyhydroxyalkanoate
- Polyhydroxybutyrat
- Polyimid
- Polyisobutylen
- Polylactid (Polymilchsäure)
- Polymethacrylmethylimid
- Polymethylmethacrylat
- Polymethylpenten
- Polyoxymethylen oder Polyacetal
- Polyphenylenether
- Polyphenylensulfid
- Polyphthalamid
- Polypropylen
- Polypropylen-Copolymere
- Polypyrrol
- Polystyrol
- Polysulfon
- Polytetrafluorethylen
- Polytrimethylenterephthalat
- Polyurethan
- Polyvinylacetat
- Polyvinylbutyral
- Polyvinylchlorid (Hart-PVC)
- Polyvinylchlorid (Weich-PVC)
- Polyvinylidenfluorid
- Polyvinylpyrrolidon
- Styrol-Acrylnitril- Copolymerisat
- Styrol-Butadien-Kautschuk
- Styrol-Butadien-Styrol
- Synthetischer Kautschuk
- Thermoplastisches Polyurethan
- Ungesättigter Polyester
- Vinylacetat-Copolymere
- Vinylchlorid/ Ethylen/ Methacrylat
- Vinylchlorid/Ethylen
- Vinylchlorid-Vinylacetat-Copotymere
- Weichgemachtes Polyvinylchlorid

Als eigenständige Erfindung wird außerdem eine Vorrichtung zum Prägen eines Prägemusters auf einer Prägefläche mit folgenden Merkmalen offenbart:
- eine Stempelaufnahme zur Aufnahme und Bewegung eines Stempels bzw. Stempelsystems, insbesondere gemäß einem vorbeschriebenen Stempel bzw. Stempelsystem,
- einer Prägematerialaufnahme zur Aufnahme und Anordnung eines Prägematerials gegenüber dem Stempel,
- einen Prägeelementantrieb zur Bewegung eines, insbesondere nach einem wie vorliegend beschrieben ausgebildeten, Prägeelements entlang des Stempels.

Vorrichtungsgemäß wird auch eine Steuerungseinrichtung zur Steuerung des beschriebenen, erfindungsgemäßen Verfahrens und zur Ausführung der beschriebenen Bewegungen der Bauteile der Vorrichtung und/oder des Strukturstempels, oder des Prägeelements, einzeln oder gemeinsam, offenbart. Entsprechende Antriebe und Führungselemente zur Ausführung der Bewegungen werden hierdurch ebenfalls der Vorrichtung zugeordnet.

Ein weiterer, insbesondere eigenständiger, Aspekt betrifft Entformungsmittel, mit deren Hilfe man den Stempel bzw. das Stempelsystem optimal von der Prägemasse trennen kann. Der Stempel wird von mindestens einer Spannleiste fixiert, welche über ein Hebesystem in z-Richtung bewegt werden kann. Die Spannleiste ist, insbesondere über andere Bauteile, rotierbar im Hebesystem gelagert. Gleichzeitig kann das Hebesystem in einer zweiten Richtung, insbesondere x-Richtung, bewegt werden, sodass die Spannleiste erfindungsgemäß entlang einer beliebigen Entformungskurve bewegt werden kann. Bei der Entformungskurve handelt es sich insbesondere um eine der folgenden Funktionen:
- Polynom, insbesondere
   o Gerade,
   o Parabel
- Wurzelfunktion
- Logarithmusfunktion
- Trigonometrische Funktion, insbesondere
   o Sinusfunktion
- Stufenfunktion

Die Translationsgeschwindigkeit der Entformungsmittel in x- und/oder z-Richtung liegt zwischen 0.1 mm/s und 100 mm/s, vorzugsweise zwischen 1 mm/s und 75 mm/s, noch bevorzugter zwischen 5 mm/s und 50 mm/s.

Als eigenständige Erfindung wird außerdem ein Verfahren zum Prägen eines Prägemusters auf einer Prägefläche eines Prägematerials mit folgenden Schritten, insbesondere folgendem Ablauf, offenbart:
- Anordnung der Stempelfläche eines Strukturstempels bzw. eines Stempelsystems, insbesondere gemäß obiger Beschreibung, gegenüber dem Prägematerial,
- Bewegung eines Prägeelements entlang des Strukturstempels und dabei Prägen des Prägematerials durch Beaufschlagung des Prägematerials mit der Stempelfläche.

Bei entsprechend großen Ausführungen der erfindungsgemäßen Vorrichtung muss die Prägekraft entsprechend groß sein. Die Prägekraft wird vorzugsweise pro Meter angegeben. Es werden folgende beispielhafte Wertebereiche für eine erfindungsgemäße Ausführung der Erfindung offenbart. Die beaufschlagende Prägekraft pro Meter liegt im Wertebereich zwischen 0N/m und 1000N/m, mit Vorzug zwischen 10N/m und 500N/m, mit größerem Vorzug zwischen 25N/m und 250N/m, mit allergrößtem Vorzug zwischen 50N/m und 100N/m. Die Prägekraft kann, insbesondere über Rezepte die in einer Soft- und/oder Firm-und/oder Hardware hinterlegt sind, geregelt werden. Des Weiteren ist eine dynamische Veränderung der Prägekraft während des Prägevorgangs denkbar. Unter dynamischer Veränderung versteht man, dass die Regelung an nicht vorhersehbare Umstände angepasst wird. Beispielsweise könnte in einem Rezept vermerkt werden, wie die Prägekraft als Funktion des Ortes aufzubringen ist. Wird während des Prägevorgangs eine Kraft gemessen, die von der Sollkraft abweicht, beispielsweise auf Grund einer vorhandenen Unebenheit im Probenhalter oder Substrat, so kann die Prägekraft auf den Sollwert nachgeregelt werden.

Ein anderer, insbesondere eigenständiger, Gegenstand der vorliegenden Erfindung betrifft eine Anlage zum Prägen von Mikro- und/oder Nanostrukturen in ein Prägematerial (in dieser Beschreibung auch Prägemasse genannt), aufweisend einen Strukturstempel bzw. ein Stempelsystem und ein bewegliches Prägeelement, dadurch gekennzeichnet, daß eine Entformung des Strukturstempels von dem Prägematerial gezielt steuerbar ist, wobei eine Spannleiste zum Fixieren des Strukturstempels entlang einer Entformungskurve beweglich ist.

Ein anderer, insbesondere eigenständiger, Gegenstand betrifft ein Verfahren zum Prägen von Mikro- und/oder Nanostrukturen, wobei ein bewegliches Prägeelement durch Krafteinwirkung auf einen Strukturstempel die Mikro-und/oder Nanostrukturen in die Prägemasse prägt, dadurch gekennzeichnet, daß eine Entformung des Strukturstempels von der Prägemasse gezielt gesteuert wird, wobei eine Spannleiste zum Fixieren des Strukturstempels entlang einer Entformungskurve beweglich ist.

Ein anderer, insbesondere eigenständiger, Gegenstand betrifft ein Stempelsystem, aufweisend einen Strukturstempel, insbesondere einen Weichstempel, zum Prägen von Mikro- und/oder Nanostrukturen und einen mit dem Strukturstempel, insbesondere flächig, verbundenen Träger, insbesondere aus Glas, wobei der Strukturstempel und der Träger derart elastisch ausgebildet sind, dass sie durch ein Prägeelement verformbar sind, wobei eine Spannleiste zum Fixieren des Strukturstempels entlang einer Entformungskurve beweglich ist.

Ein anderer, insbesondere eigenständiger, Gegenstand betrifft Entformungsmittel zum Trennen eines Strukturstempels von einem Prägematerial für eine erfindungsgemäße Anlage bzw. Verfahren, wobei die Entformungsmittel zur Bewirkung einer linearen Bewegung, vorzugsweise normal auf eine Prägefläche gerichtet, einer Seite des Strukturstempels ausgebildet sind.

Ein anderer, insbesondere eigenständiger, Gegenstand betrifft ein Prägeelementaufhängungssystem zur Aufhängung eines Prägeelements einer erfindungsgemäßen, Anlage, das derart ausgebildet, dass eine auf einen Strukturstempel und/oder einen Träger des Strukturstempels wirkende Kraft durch eine Gegenkraft gezielt einstellbar ist.

Die Beschreibung von weiteren Aspekten, Merkmalen und/oder Ausführungsformen der Erfindung bezieht sich gleichermaßen auf die Anlagen, die Verfahren, das Stempelsystem, die Entformungsmittel, und/oder das Prägeelementaufhängungssystem.

In einer bevorzugten Ausführungsform ist die Anlage bzw. das Verfahren zum step-and-repeat-Betrieb ausgebildet.

In einer anderen bevorzugten Ausführungsform ist vorgesehen, dass Entformungsmittel zum Trennen des Strukturstempels von dem Prägematerial vorgesehen sind.

In einer anderen bevorzugten Ausführungsform sind die Entformungsmittel zur Bewirkung einer linearen Bewegung, vorzugsweise normal auf eine Prägefläche gerichtet.

In einer anderen bevorzugten Ausführungsform weisen die Entformungsmittel Stäbe, bevorzugt gelagerte Linearelemente, auf.

In einer anderen bevorzugten Ausführungsform sind die Entformungsmittel mit dem Strukturstempel, insbesondere an einem Spannleisten, der den Strukturstempel und/oder einen Träger mit dem Strukturstempel hält, verbunden.

In einer anderen bevorzugten Ausführungsform weist die Anlage bzw. das Verfahren eine Prägeelementaufhängungseinrichtung (in dieser Beschreibung auch Prägeelementaufhängungssystem genannt) auf, die derart ausgebildet ist, dass eine auf den Strukturstempel und/oder einen Träger des Strukturstempels wirkende Kraft durch eine Gegenkraft gezielt einstellbar ist.

Bevorzugt ist vorgesehen, dass die Prägeelementaufhängungseinrichtung als drehbar gelagerte Wippe und/oder Träger und/oder als Spirale ausgebildet ist.

In der Erfindung ist vorgesehen, dass der Strukturstempel, insbesondere seitlich, von mindestens einer Spannleiste fixiert ist, wobei die mindestens eine Spannleiste, insbesondere über ein Hebesystem, senkrecht zu einer Prägefläche und/oder in einer Z-Richtung beweglich ist.

Bevorzugt ist weiterhin vorgesehen, dass die Spannleiste rotierbar gelagert ist, insbesondere rotierbar um eine Rotationsachse, die parallel zur Prägefläche und/oder senkrecht zur Z-Richtung und/oder senkrecht zur Bewegungsrichtung des Prägeelements und/oder parallel zur Y-Richtung angeordnet ist. Bevorzugt ist weiterhin vorgesehen, dass die mindestens eine Spannleiste, insbesondere das Hebesystem, insbesondere gleichzeitig, in einer zweiten Richtung, insbesondere in x-Richtung und/oder parallel zur Prägefläche und/oder parallel zur Bewegungsrichtung des Prägeelements, beweglich ist.

In der Erfindung ist vorgesehen, dass die Spannleiste entlang einer Entformungskurve beweglich ist, wobei es sich insbesondere bei der Entformungskurve um eine der folgenden Funktionen handelt:
- Polynom, insbesondere
   o Gerade,
   o Parabel
- Wurzelfunktion
- Logarithmusfunktion
- Trigonometrische Funktion, insbesondere
   o Sinusfunktion
- Stufenfunktion.

Bevorzugt ist weiterhin vorgesehen, dass die Translationsgeschwindigkeit der Entformungsmittel zwischen 0.1 mm/s und 100 mm/s liegt, vorzugsweise zwischen 1 mm/s und 75 mm/s, noch bevorzugter zwischen 5 mm/s und 50 mm/s.

Die Entformung des Strukturstempels bzw. des Stempelsystems von der Prägemasse erfolgt insbesondere durch die gezielte Bewegung einer Spannleiste über die Bewegung einer drehbar gelagerten Querstrebe in einer Halterung. Die Spannleiste fixiert den Stempel und ist über Federn mit einer drehbar lagerbaren Querstrebe verbunden, welche in einer translatorisch bewegbaren Halterung fixiert ist. In speziellen Ausführungsformen ist es auch denkbar, dass auf die Federn und die drehbar lagerbaren Querstrebe verzichtet wird und die Spannleiste selbst drehbar in der Halterung gelagert wird. Dadurch verliert man allerdings den technischen Vorteil des Federsystems, welches den Stempel nachgiebig fixiert. Die Halterung wird dabei entlang eines Hubsystems in einer ersten Richtung gezielt bewegt. Insbesondere gleichzeitig kann eine translatorische Bewegung des Hubsystems entlang einer zweiten Richtung, insbesondere entlang einer Schiene, erfolgen.

Durch die Kombination beider Bewegungen kann die Spannleiste entlang einer beliebigen Kurve bewegt werden. Insbesondere gleichzeitig wirkt das Prägeelement auf den Strukturstempel bzw. das Stempelsystem und beeinflusst so maßgeblich das Ablösen des Strukturstempels bzw. des Stempelsystems von der Prägemasse.

Die folgenden Überlegungen beschreiben die resultierenden Kräfte, die zu einer Bewegung der betrachteten Teilsysteme führen, nicht die Schnittkräfte. Die Kräfte sind im Allgemeinen Funktionen der Zeit.

Das Prägeelement drückt mit einer Kraft F_{R(t)} auf den Strukturstempel. Die Kraft F_{R(t)} kann in eine horizontale Kraft F_{RH(t)} und eine vertikale Kraft F_{RV(t)} zerlegt werden.

Gleichzeitig ziehen die Entformungsmittel (in dieser Beschreibung auch Entformungselemente genannt) den Strukturstempel ab und erzeugen so eine Kraft F_{S(u,t)} die ebenfalls in eine horizontale Kraft F_{SH(u,t)} und eine vertikale Kraft F_{SV(u,t)} zerlegt werden kann. Die Kraft F_{S(u,t)} wirkt in jedem Punkt des Strukturstempels, ändert aber mit der Position im Strukturstempel im Allgemeinen seine Richtung.

Daher werden die Kräfte F_{S(u,t)}, F_{SH(u,t)} und F_{SV(u,t)} neben der Zeit zusätzlich als Funktionen der Koordinate u angegeben, wobei u die Position entlang des, insbesondere auch gekrümmten, Strukturstempels, ausgehend von einem seiner Enden ist.

Durch die Bewegung, insbesondere Beschleunigung, von Prägeelement und Entformungselement können so die Kräfte F_{S(u,t)}, F_{SH(u,t)} und F_{SV(u,t)} gezielt eingestellt werden und so die Entformung des Strukturstempels von der Prägemasse gezielt gesteuert werden.

Insbesondere werden große Kraftkomponenten F_{SV(u,t)} und kleine Kraftkomponenten F_{SH(u,t)} in der Nähe der Entformung bevorzugt. Dadurch werden die Nanostrukturen des Strukturstempels überwiegend aus den geprägten Strukturen der Prägemasse herausgehoben, während eine seitliche Kraftbeaufschlagung der geprägten Nanostrukturen der Prägemasse weitestgehend unterbleibt.

Die Steuerung der Kräfte erfolgt insbesondere durch Hard- und/oder Firm-und/oder Software. Insbesondere existieren Kraftmesssensoren in den Entformungsmitteln und/oder im Prägeelement.

Große Radien des Prägeelements, insbesondere einer Prägerolle, begünstigen eine größere Kraftkomponenten F_{SH(u,t)}, geben aber den Nanostrukturen des Strukturstempels über eine längere Strecke die Möglichkeit, sich weitestgehend in Normalenrichtung zur Prägefläche aus dem geprägten Nanostrukturen der Prägemasse zu entformen. Kleine Radien des Prägeelements hingegen begünstigen eine größere Kraftkomponenten F_{SV(u,t)}, was die Entformung in Normalenrichtung zur Prägefläche begünstigt und werden relativ rasch in Normalenrichtung zur Prägefläche entformt.

Insbesondere kann durch einen vorgegebenen Radius des Prägeelements der Ablösewinkel α konstant gehalten werden. Der Ablösewinkel ist definiert als der Winkel zwischen der Horizontalen und der Tangente an die Krümmungskurve der Nanostrukturen. Der Ablösewinkel ist insbesondere kleiner als 5°, vorzugsweise kleiner als 1°, noch bevorzugter kleiner als 0.1°, am bevorzugtesten kleiner als 0.01°, am allerbevorzugtesten kleiner als 0.001°. Insbesondere ist das gesamte mikroskopische entformungsverhalten konstant über die gesamte zu entformende Fläche.

Die notwendige Kraft zum Ablösen der Nanostrukturen des Strukturstempels von den geprägten Nanostrukturen der Prägemasse ist insbesondere auch abhängig von der Größe der Nanostrukturen. Je kleiner die Nanostrukturen, desto größer ist deren gesamte freie Oberfläche und desto größer ist die zu überwindende Haftreibung zwischen den Nanostrukturen des Strukturstempels und den geprägten Nanostrukturen der Prägemasse. Des Weiteren spielt das Aspektverhältnis, also das Verhältnis zwischen der Höhe und der Breite bzw. Länge der Strukturen, eine entscheidende Rolle. Derartige Überlegungen sind vor allem von Bedeutung, wenn die Nanostrukturdichte eine Funktion des Ortes ist.

Die notwendige Kraft zum Ablösen der Nanostrukturen kann durch die Kraftmesssensoren, die sich insbesondere in den Entformungsmitteln und/oder im Prägeelement befinden, genau gemessen und durch die vorhandenen Regelungssysteme geregelt werden. Durch ein gezieltes Zusammenspiel der Kraft- und Positionssteuerung des Rollenstempels und der übrigen Entformungselemente können die Richtung und die Größe der Entformungskraft gezielt gesteuert werden. Dies kann entweder über ein Rezept oder über eine Regelschleife und die Festlegung von Grenzparametern dynamisch während des Entformungsvorgangs erfolgen. Dabei werden vorzugsweise bereits vermessene und/oder berechnete Entformungskräfte als Grenzparameter verwendet. Überschreitet oder Unterschreitet eine Kraft den entsprechend vorgegebenen Grenzwert, wird durch die Regelschleife sofort auf den gewünschten Soll-Wert zurückgeregelt.

Es kann notwendig sein, das Prägeelement beim Verformungsgang abhängig von der Nanostrukturdichte mit einer inhomogenen Linienkraft zu beaufschlagen. Denkbar wäre beispielsweise, dass die Nanostrukturen entlang der y-Richtung von der linken Seite zur rechten Seite hin dichter werden. Damit steigt entlang der y-Richtung von links nach rechts die notwendige Ablösekraft. Dementsprechend muss der Strukturstempel an der rechten Seite stärker mit einer Kraft beaufschlagt werden. Am einfachsten wird das dadurch bewerkstelligt, dass die Spannleiste über die mit ihr verbundenen Entformungselemente entlang der gesamten Länge der y-Richtung mit einer konstanten, homogenen Kraft beaufschlagt wird, das Prägeelement aber auf der rechten Seite mit einer, im Gegensatz zur linken Seite, geringeren Kraft bei der Entformung gegen den Strukturstempel drückt. Damit ist die resultierende Ablösekraft auf der rechten Seite größer.

Kraftmesssensoren können verwendet werden, um die Kraft, insbesondere die Linienkraft, zu messen. Denkbar ist eine Messung einer gemittelten Kraft oder ein Kraftverlauf entlang der Linie, auf der die Linienkraft wirkt. Durch die Messung der Kraft, welche die Prägerolle auf die Prägemasse ausübt, kann der Prägevorgang bevorzugt gesteuert und optimiert werden.

Ist das Prägeelement als Rolle konzipiert, kann die Rolle insbesondere eine Beschichtung aufweisen. Die Beschichtung kann sich positiv auf das Präge- bzw. Entformungsverhalten auswirken. Insbesondere weiche Beschichtungen erlauben eine lokale Verformung des Prägeelements und verhindern so ein zu starkes Einwirken auf die geprägten Nanostrukturen der Prägemasse. Das Beschichtungsmaterial besitzt eine Vickershärte kleiner als 10.000, vorzugsweise kleiner als 5000, noch bevorzugter kleiner als 2000, noch bevorzugter kleiner als 500, am bevorzugtesten kleiner als 100, am allerbevorzugtesten kleiner als 50. Der E-Modul des Beschichtungsmaterials ist kleiner als 1000 GPa, vorzugsweise kleiner als 500 GPa, noch bevorzugter kleiner als 200 GPa, am bevorzugtesten kleiner als 100 GPa, am allerbevorzugtesten kleiner als 10 GPa.

Eine weitere bevorzugte Ausführungsform stellt eine Rollenhalterung (auch allgemein Prägeelementaufhängungssystem oder Prägeelementaufhängungseinrichtung genannt) dar. Das Prägeelementaufhängungssystem ist so ausgeführt, dass eine auf den Stempel bzw. den Träger wirkende Kraft durch eine Gegenkraft gezielt eingestellt werden kann. Dadurch ist vorteilhaft eine sehr genaue und einfache Steuerung der auf den Stempel und/oder den Träger wirkenden Kraft möglich. Die Prägeelementaufhängungseinrichtung kann als drehbar gelagerte Wippe oder als drehbar gelagerter Träger ausgebildet sein. Alternativ kann die Prägeelementaufhängungseinrichtung als Spirale ausgebildet sein.

Vorrichtungsgemäß offenbarte Merkmale der Vorrichtung und/oder des Strukturstempels sollen auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: eine schematische Querschnittsansicht einer ersten Ausführungsform der vorliegenden Erfindung, nämlich eines erfindungsgemäßen ersten Verfahrensschrittes der Ausrichtung eines erfindungsgemäßen Strukturstempels gegenüber einem auf einem Substrat aufgebrachten Prägematerial,
- Figur 2: eine schematische Querschnittsansicht eines erfindungsgemäßen zweiten Verfahrensschrittes der Annäherung des Strukturstempels an das zu prägende Prägematerial,
- Figur 3: eine schematische Querschnittsansicht eines dritten Verfahrensschrittes der Beaufschlagung des Strukturstempels mit einem Prägeelement (Beginn des Prägens),
- Figur 4: eine schematische Ansicht des Verfahrensschritts gemäß Figur 3 beim Ende des Prägens,
- Figur 5: eine schematische Ansicht einer erfindungsgemäßen ersten Anlage in einer ersten Position,
- Figur 6: eine schematische Ansicht der ersten Anlage in einer zweiten Position,
- Figur 7a: eine schematische Ansicht der ersten Anlage in einer dritten Position, insbesondere einer Entformungsposition,
- Figur 7b: eine schematische, vergrößerte Ansicht eines Teilbereichs zwischen Strukturstempel und Prägemasse,
- Figur 8: eine schematische Ansicht eines Moduls für eine zweite Anlage,
- Figur 9a: eine schematische Vorderansicht einer erfindungsgemäßen zweiten Anlage ausgelegt für einen Step-and-Repeat Prozess,
- Figur 9b: eine schematische Oberansicht der erfindungsgemäßen zweiten Anlage,
- Figur 10a: eine schematische Liniendarstellung eines ersten erfindungsgemäßen Prägeelementaufhängungssystems,
- Figur 10b: eine schematische Liniendarstellung eines zweiten erfindungsgemäßen Prägeelementaufhängungssystems,
- Figur 10c: eine schematische Liniendarstellung eines dritten Prägeelementaufhängungssystems,
- Figur 11a: eine schematische Darstellung der Anwendung des ersten erfindungsgemäßen Prägeelementaufhängungssystems in einer ersten Position,
- Figur 11b: eine schematische Darstellung des Prägeelementaufhängungssystems in einer zweiten Position, und
- Figur 11c: eine schematische Darstellung des Prägeelementaufhängungssystems in einer dritten Position.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

In den Figuren sind die erfindungsgemäßen Merkmale nicht maßstabsgetreu dargestellt, um die Funktion der einzelnen Merkmale überhaupt darstellen zu können. Auch die Verhältnisse der einzelnen Bauteile sind teilweise unverhältnismäßig, was insbesondere auf stark vergrößert dargestellte Nanostrukturen 2e und 31 zurückzuführen ist.

Die Nanostrukturen 2e eines Strukturstempels 2, die zum Prägen von korrespondierenden Nanostrukturen 31 auf Werkstücke verwendet werden, liegen im Nano- und/oder Mikrometerbereich, während die Größenordnung der Maschinenbauteile im Zentimeterbereich liegt.

Insbesondere ist das Verhältnis zwischen der Dicke eines Trägers 17 und der Dicke einer Stempelfläche 2 nicht maßstabsgetreu dargestellt. Die Dicke der Stempelfläche 2 ist um mehrere Größenordnungen kleiner als die Dicke des Trägers 17.

Die Abmessungen der einzelnen Nanostrukturen 2e der Stempelfläche 2 liegen vorzugsweise im Mikrometer- und/oder im Nanometerbereich. Die Abmessungen der einzelnen Nanostrukturen 2e sind kleiner als 1000 µm, mit Vorzug kleiner als 10 µm, mit größerem Vorzug kleiner als 100 nm, mit noch größerem Vorzug kleiner als 75 nm, mit allergrößtem Vorzug kleiner als 50 nm.

Die Dicke des Trägers 17 ist kleiner als 2000 µm, mit Vorzug kleiner als 1000 µm, mit größerem Vorzug kleiner als 500 µm, mit noch größerem Vorzug kleiner als 100 µm, mit allergrößtem Vorzug kleiner als 10 µm.

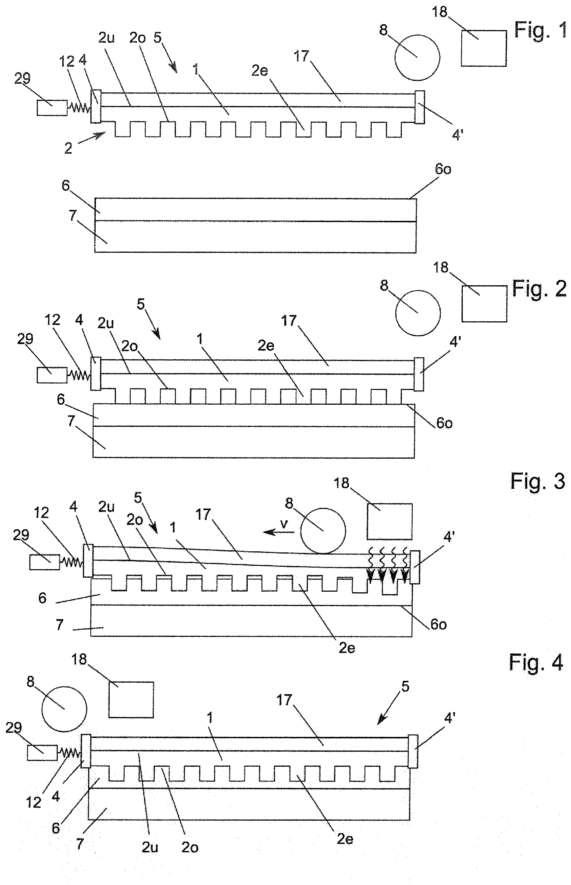

In der in Figuren 1 bis 4 ist ein erfindungsgemäßer Prägeprozess in den einzelnen Schritten dargestellt.

Ein Stempelsystem 5 weist einen Stempel 1 (im Folgenden auch Strukturstempel 1 genannt) auf, der an einem Träger 17 befestigt ist.

Der Stempel 1 besitzt eine mikro- oder nanostrukturierte Stempelfläche 2 mit Nanostrukturen 2e (Erhebungen), die von einer Prägeseite 2o des Stempels 1 hervorstehen.

Eine zur Stempelfläche 2 gegenüberliegende Beaufschlagungsseite 2u ist plan eben ausgebildet, damit eine möglichst homogene Beaufschlagung des Stempels 1 an der Beaufschlagungsseite 2u ermöglicht wird.

Zur Beaufschlagung dient ein Prägeelement 8, vorzugsweise in Form einer Prägerolle, die nach Ausrichtung des Stempelsystems 5 gegenüber einem auf einem Substrat 7 aufgebrachten Prägematerial 6 (siehe Figur 1) und anschließendem Annähern des Stempelsystems 5 an eine Prägefläche 6o des Prägematerials 6 auf die Beaufschlagungsseite 2u abgesenkt wird.

Die erfindungsgemäße Ausführungsform verfügt über zwei Spannleisten 4, 4', in welche das Stempelsystem 5 eingespannt ist. Mindestens eine der Spannleisten 4, 4' ist entweder starr oder über ein Federsystem, bestehend aus mehreren Federn 12, mit einer drehbar gelagerten Querstrebe 29 verbunden.

Die Verwendung eines Federsystems als Kupplung zwischen mindestens einer der Spannleisten 4, 4' und der drehbar gelagerten Querstrebe 29 dient der Erhöhung der Flexibilität des Stempels 1 bei Beanspruchung durch das Prägeelement 8.

Das Federsystem besteht aus mindestens zwei, mit Vorzug aus mehr als fünf, mit größerem Vorzug aus mehr als zehn, mit größtem Vorzug aus mehr als 20 Federn 12.

Die Beaufschlagung der Beaufschlagungsseite 2u mit dem Prägeelement 8 erfolgt insbesondere gleichzeitig mit einer Kontaktierung beziehungsweise einem Eintauchen der Nanostrukturen 2e in das Prägematerial 6 (siehe Figur 3), wobei die Annäherung des Stempelsystems 5 an das Prägematerial 6 gemäß Figur 2 vorzugsweise parallel (gegebenenfalls unter minimaler Anwinklung (Keilfehler) des Stempelsystems 5) erfolgt.

Die Nanostrukturen 2e tauchen in das, insbesondere aus einem Material niedriger Viskosität bestehende, Prägematerial 6 ein und während des Annäherns des Stempelsystems 5 an das Prägematerial 6 wird, insbesondere unter Parallelisierung des Stempels 1 mit dem Prägematerial 6, eine Prägekraft auf die Beaufschlagungsseite 2u durch das Prägeelement 8 übertragen.

Dabei verformt sich der Stempel 1 in Richtung des Prägematerials. Diese Verformung des Stempels 1 ist minimal. Eine Verformung des Stempels 1 geht mit einer Verzerrung seiner Nanostrukturen 2e einher.

Denkbar ist auch eine leicht angewinkelte Annäherung des erfindungsgemäßen Stempelsystems 5 zur Oberfläche des Prägematerials 6 zunächst an einer der beiden Spannleisten 4, 4', so dass das Eintauchen der Nanostrukturen 2e nach und nach erfolgt.

Das Prägeelement 8 wird unter Annäherung des Stempels 1 (und ggf. Parallelisierung des Stempels 1) zu dem Prägematerial 6, insbesondere überwiegend durch die Prägekraft des Prägeelements 8 bewirkt, von der ersten Spannleiste 4 zur gegenüberliegend angeordneten zweiten Spannleiste 4' parallel zu der Oberfläche des Prägematerials 6 bewegt.

Nach Erreichen der Position gemäß Figur 4 ist die Stempelfläche 2 vollständig in dem Prägematerial 6 eingetaucht und dort entsprechend abgebildet.

Anschließend, oder sogar gleichzeitig während des Prägens, erfolgt eine Aushärtung des Prägematerials 6 und nach Aushärtung des Prägematerials 6 kann das Stempelsystem 5 erfindungsgemäß entformt werden.

Die Aushärtung kann durch alle bekannten Verfahren von der Vorder- und/oder Rückseite erfolgen, beispielsweise durch UV-Strahlung, durch Chemikalien oder durch Wärme, sowie durch eine Kombination der genannten Methoden.

Der Einsatz einer Prägerolle als Prägeelement 8 bringt den Vorteil einer abrollenden Bewegung und Druckbeaufschlagung mit der Prägekraft mit sich, was zu einer Minimierung von Scherkräften auf dem Stempel 1 führt. Des Weiteren kann auf einen komplizierten Keilfehlerausgleich weitgehend verzichtet werden, der unabdingbar wäre, wenn man den Stempelprozess durch eine Normalbewegung des Stempels und des Prägematerials zueinander durchführen wollte. Durch diese Art der Kontaktierung ist auch sichergestellt, dass Luft entweichen kann und die korrekte Abformung der Strukturen nicht durch Lufteinschlüsse beeinträchtigt wird.

Das Prägeelement 8 kann alternativ derart ausgeführt sein, dass eine kontaktlose Kraftübertragung, insbesondere durch einen Gasstrom aus einer linienförmigen Düse und/oder mehreren entlang einer Linie angeordneten, punktförmigen Düsen, erfolgt.

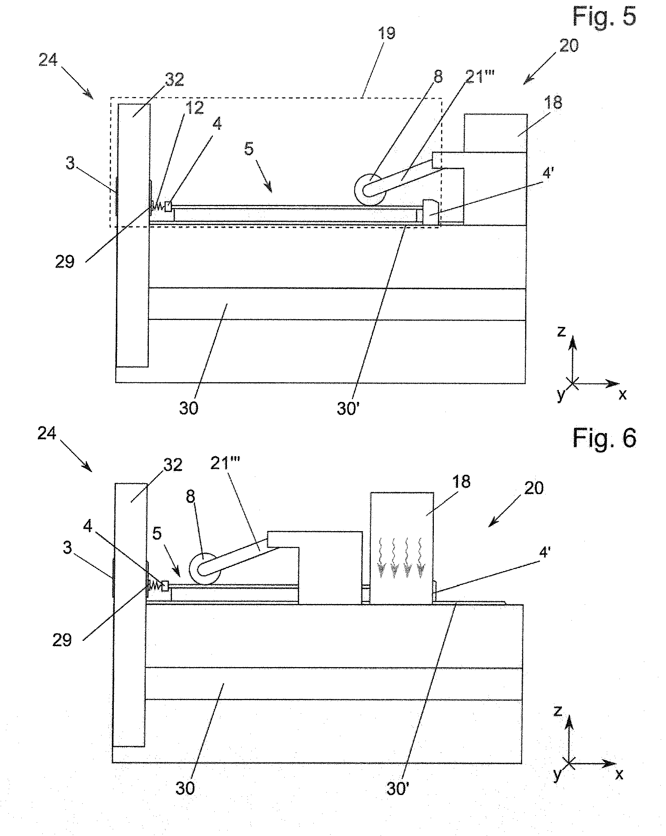

Die Figur 5 zeigt eine erste erfindungsgemäße Anlage 24 mit einem Modul 20, aufweisend mindestens ein, insbesondere nachfahrendes, Lampenhaus 18, ein Prägeelement 8, insbesondere eine Rolle 8, ein Stempelsystem 5 und mehrere Bauteile 8, 21"', 4,12, 29, 3,32, die im Weiteren unter der Bauteilgruppe Entformungsmittel 19 zusammengefasst werden, in einer ersten Position. Die Bauteilgruppe Entformungsmittel 19 wird von einem gestrichelten Rechteck umrandet, um sie besser bezeichnen zu können.

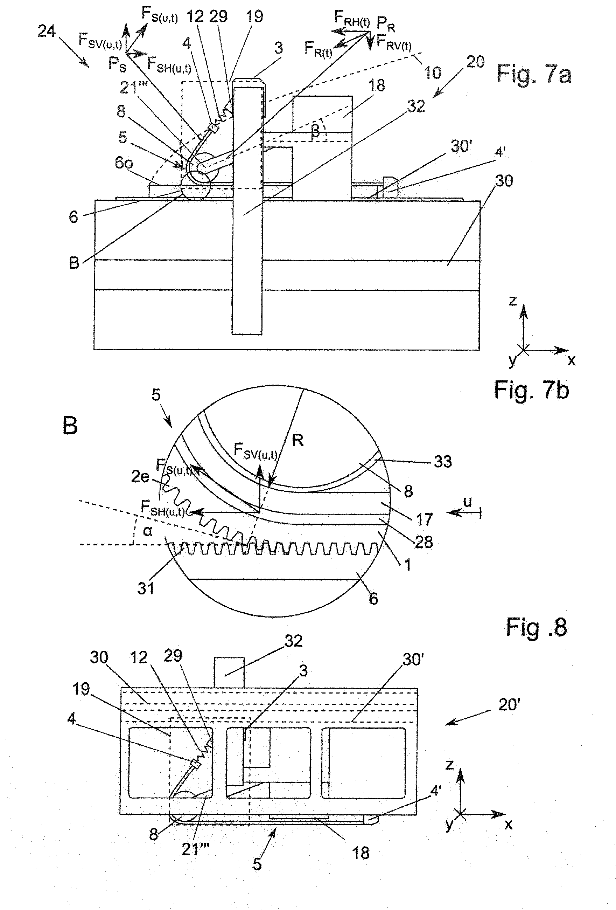

Die Entformungsmittel 19 sind besonders gut in der Figur 7a zu erkennen, wo sich deren Bauteile in einem erfindungsgemäßen Entformungsschritt nahe beieinander befinden und ebenfalls von einem gestrichelten Rechteck umrandet werden um klar hervorgehoben zu werden. Ersichtlich ist auch, dass die Bauteile 8, 21'" genauso an der Prägung wie auch der späteren erfindungsgemäßen Entformung teilnehmen. Das Prägeelement 8 wird von einem Prägeelementaufhängungssystem 21 '" aufgenommen.

In Fig. 5 befinden sich das Prägeelement 8 und das Lampenhaus 18 in der ersten, insbesondere als Ausgangsposition bezeichneten, Position. Das Stempelsystem 5 wurde vorzugsweise bereits so in Position gebracht, dass eine Prägung durch eine Kraftübertragung durch das Prägeelement 8 beginnen kann.

Die Figur 6 zeigt die Anlage 24 bzw. das vorher beschriebene Modul 20 in einer zweiten Position. Die zweite Position zeichnet sich vor allem dadurch aus, dass mit der translatorischen Bewegung des Prägeelements 8 eine Nachrückung des Lampenhauses 18 erfolgt.

Die Nachrückung kann dabei entweder gleichzeitig, daher synchron, mit der Bewegung des Prägeelements 8 oder zeitverzögert erfolgen. Die Bewegung des Lampenhauses 18 kann insbesondere auch langsamer sein als die Bewegung des Prägeelements 8. In der Figur 6 bleibt das Lampenhaus 18 exemplarisch hinter der Prägerolle 8 zurück. Erfindungsgemäß von Bedeutung ist, dass das Lampenhaus 18 immer nur Teilabschnitte von dem Prägematerial 6 (nicht eingezeichnet, da vom Stempelsystem 5 verdeckt) belichtet. Die Belichtung wird durch vier Pfeile symbolisch dargestellt.

Durch diese erfindungsgemäße Ausführungsform ist eine Beschränkung der Größe des Lampenhauses 18, insbesondere der Lichtquelle, möglich. Sollte die erfindungsgemäße Ausführungsform nicht über ein nachfahrendes Lampenhaus, sondern eine vollflächige Belichtung verfügen, so befindet sich diese oberhalb des genannten Moduls und ist entsprechend befestigt. Eine derartige Ausführungsform wurde nicht eingezeichnet.

Die Figur 7a zeigt die erste Anlage 24 bzw. das erste Modul 20 in einer dritten Position. Diese Position zeichnet sich durch die Ablösung des Stempelsystems 5 von dem Prägematerial 6 aus.

Die Entformung erfolgt insbesondere durch ein Zusammenwirken der Bauteile 21"', 8, 4, 12, 29, 3, 32, die als Bauteilgruppe Entformungsmittel 19 (gestrichelt umrandet dargestellt) bezeichnet werden. Jedes der genannten Bauteile trägt seinen Teil zu einer erfindungsgemäßen Entformung des Stempelsystems 5 von der Prägemasse 6 bei.

Über das Prägeelementaufhängungssystem 21"' wird eine Kraft F_{R(t)} auf die Prägerolle 8 übertragen. Insbesondere kann durch einen entsprechenden Anstellwinkel β des Aufhängungssystems 21'" die Kraftrichtung beeinflusst werden.

Die Prägerolle 8 wirkt mit der übertragenen Kraft F_{R(t)} auf das Stempelsystem 5, welches insbesondere gleichzeitig mit einer Kraft F_{S(u,t)} gespannt wird. Die Kräfte wurden nicht direkt in den jeweiligen Bauteilen, insbesondere nicht an den Kraftwirkungspunkten eingezeichnet, sondern der Übersichtlichkeit halber aus der Zeichnung herausgezogen. Die eingezeichneten Linien verweisen aber auf deren Kraftwirkungspunkte P_{S} und P_{R}.

Dem Stempelsystem 5 wird die Kraft über die Spannleiste 4, das Federsystem, insbesondere über die Federn 12, von der drehbar gelagerten Querstrebe 29 übertragen. Die Querstrebe 29 muss in einer Halterung 3 drehbar gelagert sein, damit sich die Bauteile 4 und 12 bei der Bewegung nach rechts entsprechend mitrotieren können.

Die Halterung 3 kann insbesondere über ein Hebesystem 32 entlang der z-Richtung auf und ab bewegt werden. Gleichzeitig kann das Hebesystem 32 sich entlang einer Schiene 30 in x-Richtung bewegen. Durch diese Freiheitsgrade ist das Anfahren eines jeden Punktes in einer x-z Ebene möglich.

Durch die Bewegung dieser Bauteile kann die Spannleiste 4, die hier als Ansatzpunkt dient, da sie die größte Nähe zum Stempelsystem 5 besitzt, beliebig verfahren werden und damit eine beliebige Kraft F_{S(u,t}) im Stempel 1 erzeugen. Insbesondere bewegt sich die Spannleiste 4 entlang einer gewünschten Entformungskurve 10.

Unabhängig davon kann auch das Prägeelement 8 über das Prägeelementaufhängungssystem 21'" eine beliebige Kraft auf das Stempelsystem 5 ausüben. Die aus diesen Kräften resultierende Kraft beeinflusst die Entformung des Stempelsystems 5 von der Prägemasse 6.

Die Figur 7b zeigt eine schematische, vergrößerte Ansicht des Prägebereichs B zwischen dem Stempelsystem 5 und der Prägemasse 6. Erkennbar ist ein Prägeelement 8, insbesondere mit einer Beschichtung 33, das den Träger 17 rückseitig kontaktiert. Der Träger 17 ist mit einer Verbindungsschicht 28 mit dem Stempel 1 verbunden. Die Position im Stempelsystem 5 wird durch die Koordinate u angegeben.

Der Stempel 1 verfügt über Nanostrukturen 2e, die bei der Entformung von der Prägemasse 6, geprägte Nanostrukturen 31 zurücklassen. In einem Punkt des Stempelsystems 5 ist die wirkende, resultierende Kraft F_{S(u,t)} eingezeichnet, welche die Entformung bewirkt.

Diese kann in die horizontale und vertikale Kraftkomponenten F_{SH(ut)}, F_{SV(u,t)} zerlegt werden. Die vertikale Kraftkomponente F_{SV(u,t)} ist maßgeblich an der Entformung der Nanostrukturen 2e aus der Prägemasse 6 beteiligt, während die horizontale Kraftkomponente F_{SH(u,t)} eine Reibung der Nanostrukturen 2e an den geprägten Nanostrukturen 31 begünstigt. Erkennbar ist auch der Ablösewinkel α, der bereits in dieser Offenbarung beschrieben wurde.

Die Figur 8 zeigt ein zweites erfindungsgemäßes Modul 20', das so konzipiert wurde, dass das Stempelsystem 5 das am tiefsten liegende Bauteil darstellt. Die Verwendung der dargestellten Bauteile erfolgt analog. Insbesondere kann das Modul, anstatt eines nachfahrenden Lampenhauses 18 eine Belichtungsanlage zur vollflächigen Belichtung des Stempelsystems 5 aufweisen.

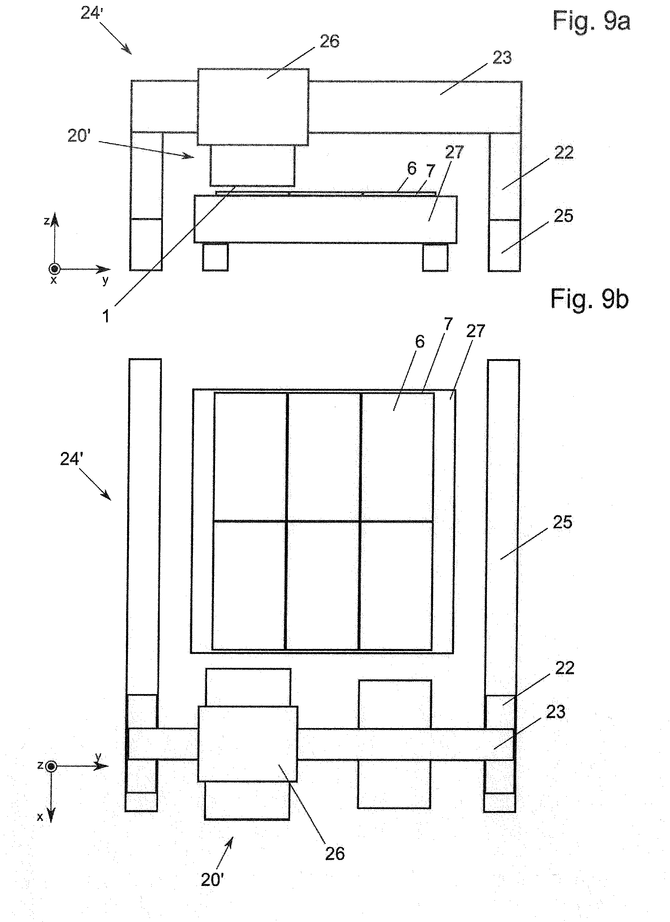

Die Figur 9a zeigt eine schematische Vorderansicht einer erfindungsgemäßen zweiten Anlage 24', aufweisend ein Modul 20'. Das Modul 20' ist über eine Aufhängung 26 an einem Querbalken 23 fixiert. Der Querbalken 23 ist beidseitig an jeweils einem Schlitten 22 befestigt. Die Schlitten 22 bewegen sich entlang eines Führungssystems 25.

Durch den erfindungsgemäßen Aufbau ist das Modul 20' entlang der x-Richtung und/oder entlang der y-Richtung verfahrbar. Das Modul 20' ist in diesem Fall so konzipiert, dass der Stempel 1 positionierbar ist. Insbesondere kann das Modul 20' so abgesenkt werden, dass der Abstand zwischen dem Stempel 1 und der Prägemasse 6 eines Substrats 7 auf einem Probenhalter 27 beliebig genau einstellbar ist.

Die Beanspruchung des Stempels 1 bzw. des Trägers 17 auf dem der Stempel 1 fixiert wurde, erfolgt durch das Prägeelement 8, insbesondere eine Prägerolle 8 (siehe Fig. 8). Des Weiteren ist auch die Nachführung des Lampenhauses 18 möglich.

Die Figur 9b zeigt eine schematische Oberansicht der erfindungsgemäßen zweiten Anlage 24'. Erkennbar sind sechs Substrate 7, die mit einer Prägemasse 6 beschichtet wurden und auf dem Probenhalter 27 fixiert wurden. Durch die translatorische Bewegung des Moduls 20' sind alle sechs Substrate 7 erreichbar. Denkbar ist auch, dass auf dem Probenhalter 27 ein einziges, insbesondere den gesamten Probenhalter 27 bedeckendes, Substrat 6 fixiert wird.

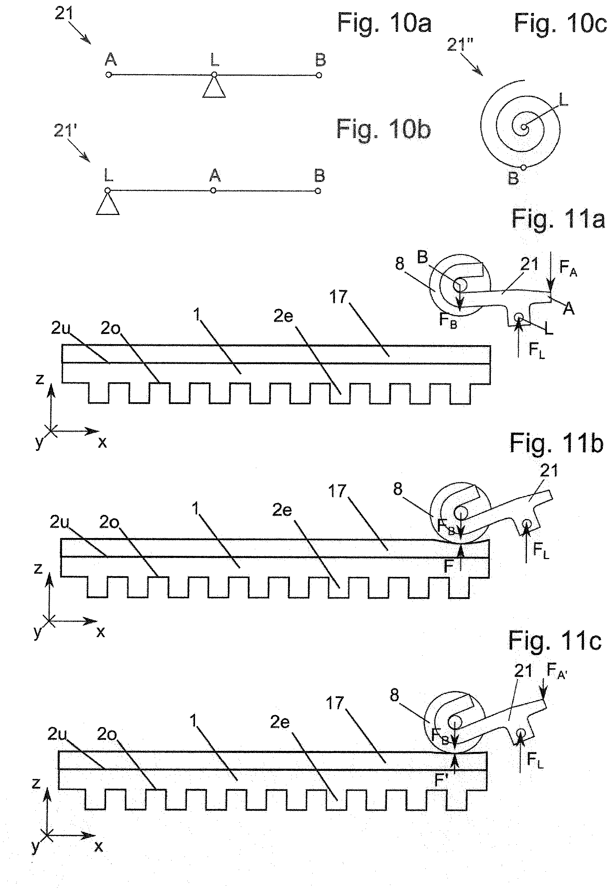

Die Figur 10a zeigt ein schematisches Liniendiagramm eines ersten erfindungsgemäßen Prägeelementaufhängungssystems 21. Bei dem Prägeelementaufhängungssystem 21 handelt es sich um eine Wippe, bestehend aus einem Lager L, einem Kraftbeaufschlagungspunkt A und einem Kraftwirkungspunkt B.

Das Prägeelement 8 wird am Kraftwirkungspunkt B befestigt. Das Prägeelementaufhängungssystem 21 ist um das Lager L drehbar gelagert. Am Kraftbeaufschlagungspunkt A können Zug- und/oder Druckkräfte ansetzen. Die Zug- und/oder Druckkräfte können über Federn, Aktuatoren, Motoren etc. aufgebracht werden.

Die Figur 10b zeigt ein schematisches Liniendiagramm eines zweiten erfindungsgemäßen Prägeelementaufhängungssystems 21'. Bei dem Prägeelementaufhängungssystem 21' handelt es sich um einen, um das Lager L drehbar gelagerten, Träger. Der Träger besitzt einen Kraftbeaufschlagungspunkt A und einen Kraftwirkungspunkt B.

Das Prägeelement 8 wird wieder am Kraftwirkungspunkt B befestigt. Am Kraftbeaufschlagungspunkt A können Zug- und/oder Druckkräfte ansetzen. Die Zug- und/oder Druckkräfte können über Federn, Aktuatoren, Motoren etc. aufgebracht werden.

Die Figur 10c zeigt ein schematisches Liniendiagramm eines dritten erfindungsgemäßen Prägeelementaufhängungssystems 21". Das Prägeelementaufhängungssystems 21" weist ein Lager L auf. Über das Lager L kann ein Moment aufgebracht werden. Das Prägeelement 8 ist wieder am Kraftwirkungspunkt B montiert.

Durch das Aufbringen eines Momentes auf die Spirale zieht sich diese zusammen und hebt den Punkt B in vertikaler Richtung an. Dadurch kann über eine Momenteneintragung eine Linearbewegung des Punktes B realisiert und damit indirekt eine Kraftsteuerung bewirkt werden.

In den weiteren Figurenbeschreibungen wird der Einfachheit halber angenommen, dass das gezeigte Prägeelementaufhängungssystem 21 masselos ist und sich der Schwerpunkt des Systems im Zentrum des Prägeelements 8 befindet. Die am Kraftbeaufschlagungspunkt A wirkenden Kräfte können durch Zug- und/oder Druckelemente erzeugt werden.

Die Figur 11a zeigt eine schematische Darstellung der Anwendung des erfindungsgemäßen ersten Prägeelementaufhängungssystems 21 in einer ersten Position. Auf das Prägeelement 8 wirkt die Gravitationskraft F_{B}. Durch eine am Kraftbeaufschlagungspunkt A wirkende Gegenkraft F_{A} kann das Prägeelementaufhängungssystem 21 im Gleichgewicht gehalten werden.

Die Figur 11b zeigt eine schematische Darstellung der Anwendung des ersten Prägeelementaufhängungssystems 21 in einer zweiten Position. Auf das Prägeelement 8 wirkt die Gravitationskraft F_{B}. Durch die Wegnahme der am Kraftbeaufschlagungspunkt A wirkenden Gegenkraft F_{A} kann das Prägeelementaufhängungssystem 21 auf den Stempel 8 bzw. den Träger 17 abgesenkt werden. Durch die entsprechende Gewichtskraft F_{B} wird der Stempel 8 und/oder der Träger 17 entsprechend verformt. In der schematischen Darstellung wurde die gemäß dem dritten Newtonschen Axiom wirkende resultierende Gegenkraft F eingezeichnet.

Die Figur 11c zeigt eine schematische Darstellung der Anwendung des ersten Prägeelementaufhängungssystems 21 in einer dritten Position. Auf das Prägeelement 8 wirkt immer noch die Gravitationskraft F_{B}. Durch eine gezielte Aufbringung einer Kraft F_{A'} am Kraftbeaufschlagungspunkt A kann die resultierende, auf den Stempel 8 und/oder den Träger 17 wirkende, Kraft beeinflusst und gesteuert werden.

Dem Fachmann ist klar, dass durch die Aufbringung einer Kraft in negativer z-Richtung die Druckkraft auf den Stempel 8 und/oder den Träger 17 reduziert und durch die Aufbringung einer Kraft in positiver z-Richtung die Druckkraft auf den Stempel 8 und/oder den Träger 17 erhöht wird. In der schematischen Darstellung wurde die, gemäß dem dritten Newtonschen Axiom wirkende, resultierende Gegenkraft F' eingezeichnet. Durch die Aufbringung der, in negative z-Richtung wirkende, Kraft F_{A'} im Kraftbeaufschlagungspunkt A, ist diese entsprechend kleiner als die entsprechende Gegenkraft F aus der Figur 14b.

Durch die Steuerung der Kraft im Kraftbeaufschlagungspunkt A wird somit eine sehr genaue und einfache Steuerung der auf den Stempel 8 und/oder den Träger 17 wirkenden Kraft möglich.

### Bezugszeichenliste

- 1: Strukturstempel
- 2: Stempelfläche
- 2e: Nanostrukturen
- 2o: Prägeseite
- 2u: Beaufschlagungsseite
- 3: Halterung
- 4, 4': Spannleisten
- 5: Stempelsystem
- 6, 6': Prägematerial
- 6o: Prägefläche
- 6u: Rückseite
- 7: Substrat
- 8: Prägeelement
- 10: Verformungskurve
- 11: Halterahmen
- 12: Feder
- 14: Flachprofil
- 15: Flachprofil
- 16: Fixiermittel
- 17: Träger
- 18: Lampenhaus
- 19: Entformungsmittel
- 20: Modul
- 21, 21', 21", 21'": Prägeelementaufhängungssystem
- 22: Schlitten
- 23: Querbalken
- 24, 24': Anlage
- 25: Führungssystems
- 26: Aufhängung
- 27: Probenhalter
- 28: Verbindungsschicht
- 29: Drehbar gelagerte Querstrebe
- 30: Schiene
- 31: Geprägte Nanostrukturen
- 32: Hebesystem
- 33: Beschichtung
- B: Prägebereich
- E: Oberflächenebene
- F_{A}, F_{A'}, F_{L}, F_{B}, F, F': Kräfte
- FR(t),FRH(t),FRV(t): Kräfte
- FS(u,t),FSH(u,t),FSV(u,t): Kräfte
- L: Lager
- PS,PR: Kraftwirkungspunkte
- u: Koordinate
- α: Ablösewinkel
- β: Ablösewinkel

## Patentansprüche

1. Anlage (24, 24') zum Prägen von Mikro- und/oder Nanostrukturen (31) in ein Prägematerial (6,6'), aufweisend einen Strukturstempel (1) und ein bewegliches Prägeelement (8), **dadurch gekennzeichnet, dass** eine Entformung des Strukturstempels (1) von dem Prägematerial (6,6') gezielt steuerbar ist, wobei eine Spannleiste (4,4') zum Fixieren des Strukturstempels (1) entlang einer Entformungskurve beweglich ist, wobei es sich insbesondere bei der Entformungskurve um eine der folgenden Funktionen handelt:
• Polynom, insbesondere
∘ Gerade,
∘ Parabel
• Wurzelfunktion
• Logarithmusfunktion
• Trigonometrische Funktion, insbesondere
∘ Sinusfunktion
• Stufenfunktion.

2. Anlage (24, 24') nach Anspruch 1, wobei die Anlage (24, 24') zum step-and-repeat-Betrieb ausgebildet ist.

3. Anlage (24, 24') nach einem der vorhergehenden Ansprüche, aufweisend Entformungsmittel (19) zum Trennen des Strukturstempels (1) von dem Prägematerial (6, 6').

4. Anlage (24, 24') nach Anspruch 3, wobei die Entformungsmittel (19) zur Bewirkung einer linearen Bewegung, vorzugsweise normal auf eine Prägefläche (60) gerichtet, einer Seite des Strukturstempels (1) ausgebildet sind.

5. Anlage (24, 24') nach Anspruch 3 oder Anspruch 4, wobei die Entformungsmittel (19) Stäbe, bevorzugt gelagerte Linearelemente, aufweisen.

6. Anlage (24, 24') nach einem der Ansprüche 3, 4 oder 5, wobei die Entformungsmittel (19) mit dem Strukturstempel (1), insbesondere an einem Spannleisten (4, 4'), der den Strukturstempel (1) und/oder einen Träger (17) mit dem Strukturstempel (1) hält, verbunden sind.

7. Anlage (24, 24') nach einem der vorhergehenden Ansprüche, aufweisend ein Prägeelementaufhängungssystem (21, 21', 21",21"'), das derart ausgebildet ist, dass eine auf den Strukturstempel (1) und/oder einen Träger (17) des Strukturstempels (1) wirkende Kraft (F,F') durch eine Gegenkraft (F_{A},F_{A}') gezielt einstellbar ist.

8. Anlage (24, 24') nach Anspruch 7, wobei das Prägeelementaufhängungssystem (21, 21', 21",21"') als drehbar gelagerte Wippe (21) und/oder Träger (21') und/oder als Spirale (21") ausgebildet ist.

9. Anlage (24, 24') nach einem der vorhergehenden Ansprüche, wobei der Strukturstempel (1), insbesondere seitlich, von mindestens einer Spannleiste (4,4') fixiert ist, wobei die mindestens eine Spannleiste (4,4'), insbesondere über ein Hebesystem (32), senkrecht zu einer Prägefläche (60) und/oder in einer Z-Richtung beweglich ist.

10. Anlage (24, 24') nach einem der vorhergehenden Ansprüche, wobei die Spannleiste (4,4') rotierbar gelagert ist, insbesondere rotierbar um eine Rotationsachse, die parallel zur Prägefläche (60) und/oder senkrecht zur Z-Richtung und/oder senkrecht zur Bewegungsrichtung des Prägeelements (8) und/oder parallel zur Y-Richtung angeordnet ist.

11. Anlage (24, 24') nach einem der vorhergehenden Ansprüche, wobei die mindestens eine Spannleiste (4,4'), insbesondere das Hebesystem (32), insbesondere gleichzeitig, in einer zweiten Richtung, insbesondere in x-Richtung und/oder parallel zur Prägefläche (60) und/oder parallel zur Bewegungsrichtung des Prägeelements (8), beweglich ist.

12. Anlage (24, 24') nach einem der Ansprüche 3, 4, 5 oder 6, wobei die Translationsgeschwindigkeit der Entformungsmittel (19) zwischen 0.1 mm/s und 100 mm/s liegt, vorzugsweise zwischen 1 mm/s und 75 mm/s, noch bevorzugter zwischen 5 mm/s und 50 mm/s.

13. Verfahren zum Prägen von Mikro- und/oder Nanostrukturen (31) in ein Prägematerial (6,6'), wobei ein bewegliches Prägeelement (8) durch Krafteinwirkung auf einen Strukturstempel (1) die Mikro- und/oder Nanostrukturen (31) in das Prägematerial (6,6') prägt, **dadurch gekennzeichnet, dass** eine Entformung des Strukturstempels (1) von der Prägemasse (6,6') gezielt gesteuert wird, wobei eine Spannleiste (4,4') zum Fixieren des Strukturstempels (1) entlang einer Entformungskurve beweglich ist, wobei es sich insbesondere bei der Entformungskurve um eine der folgenden Funktionen handelt:
• Polynom, insbesondere
∘ Gerade,
∘ Parabel
• Wurzelfunktion
• Logarithmusfunktion
• Trigonometrische Funktion, insbesondere
∘ Sinusfunktion
• Stufenfunktion.

14. Stempelsystem (5), aufweisend einen Strukturstempel (1), insbesondere einen Weichstempel, zum Prägen von Mikro- und/oder Nanostrukturen (31) und einen mit dem Strukturstempel (1), insbesondere flächig, verbundenen Träger (17), insbesondere aus Glas, wobei der Strukturstempel (1) und der Träger (17) derart elastisch ausgebildet sind, dass sie durch ein Prägeelement (8) verformbar sind, wobei eine Spannleiste (4,4') zum Fixieren des Strukturstempels (1) entlang einer Entformungskurve beweglich ist, wobei es sich insbesondere bei der Entformungskurve um eine der folgenden Funktionen handelt:
• Polynom, insbesondere
∘ Gerade,
∘ Parabel
• Wurzelfunktion
• Logarithmusfunktion
• Trigonometrische Funktion, insbesondere
∘ Sinusfunktion
• Stufenfunktion.

15. Entformungsmittel (19) zum Trennen eines Strukturstempels (1) von einem Prägematerial (6, 6') für eine Anlage (24, 24') nach einem der vorhergehenden Ansprüche, wobei die Entformungsmittel (19) zur Bewirkung einer linearen Bewegung, vorzugsweise normal auf eine Prägefläche (60) gerichtet, einer Seite des Strukturstempels (1) ausgebildet sind.

16. Prägeelementaufhängungssystem (21, 21', 21",21"") zur Aufhängung eines Prägeelements (8) einer Anlage (24,24') gemäß einem der vorhergehenden Ansprüche, derart ausgebildet, dass eine auf einen Strukturstempel (1) und/oder einen Träger (17) des Strukturstempels (1) wirkende Kraft (F,F') durch eine Gegenkraft (F_{A}, F_{A}') gezielt einstellbar ist.

## Claims

1. An apparatus (24, 24') for embossing micro- and/or nanostructures (31) in an embossing material (6, 6'), comprising a structured stamp (1) and a mobile embossing element (8), **characterised in that** a removal of the structured stamp (1) from the embossing material (6, 6') can be controlled in a targeted manner, wherein a clamping bar (4, 4') for fixing the structured stamp (1) can be moved along a removal curve, wherein the removal curve is in particular one of the following functions:
• polynomial, in particular
∘ straight-line,
∘ parabola
• root function
• logarithmic function
• trigonometric function, in particular
∘ sine function
• step function.

2. The apparatus (24, 24') according to claim 1, wherein the apparatus (24, 24') is designed for the step-and-repeat operation.

3. The apparatus (24, 24') according to any one of the preceding claims, comprising removal means (19) for separating the structured stamp (1) from the embossing material (6, 6').

4. The apparatus (24, 24') according claim 3, wherein the removal means (19) are constituted for bringing about a linear movement, preferably directed normal to an embossing surface (60), of a side of the structured stamp (1).

5. The apparatus (24, 24') according to claim 3 or claim 4, wherein the removal means (19) comprise rods, preferably mounted linear elements.

6. The apparatus (24, 24') according to any one of claims 3, 4 or 5, wherein the removal means (19) are connected to the structured stamp (1), in particular to a clamping bar (4, 4'), which holds the structured stamp (1) and/or a carrier (17) with the structured stamp (1).

7. The apparatus (24, 24') according to any one of the preceding claims, comprising an embossing element suspension system (21, 21', 21", 21'"), which is constituted such that a force (F, F') acting on the structured stamp (1) and/or a carrier (17) of the structured stamp (1) can be adjusted by a counterforce (F_{A}, F_{A}') in a targeted manner.

8. The apparatus (24, 24') according to claim 7, wherein the embossing element suspension system (21, 21', 21", 21"') is constituted as a rotatably mounted rocker (21) and/or carrier (21') and/or as a spiral (21").

9. The apparatus (24, 24') according to any one of the preceding claims, wherein the structured stamp (1) is fixed, in particular laterally, by at least one clamping bar (4, 4'), wherein the at least one clamping bar (4, 4') can be moved, in particular by means of a lifting system (32), perpendicular to an embossing surface (60) and/or in a Z-direction.

10. The apparatus (24, 24') according to any one of the preceding claims, wherein the clamping bar (4, 4') is mounted rotatably, in particular rotatable about a rotation axis which is arranged parallel to the embossing surface (60) and/or perpendicular to the Z-direction and/or perpendicular to the movement direction of the embossing element (8) and/or parallel to the Y-direction.

11. The apparatus (24, 24') according to any one of the preceding claims, wherein the at least one clamping bar (4, 4'), in particular the lifting system (32), can be moved in particular simultaneously in a second direction, in particular in the x-direction and/or parallel to the embossing surface (60) and/or parallel to the movement direction of the embossing element (8).

12. The apparatus (24, 24') according to any one of claims 3, 4, 5 or 6, wherein the translational speed of the removal means (19) lies between 0.1 mm/s and 100 mm/s, preferably between 1 mm/s and 75 mm/s, still more preferably between 5 mm/s and 50 mm/s.

13. A method for embossing micro- and/or nanostructures (31) in an embossing material (6, 6'), wherein a mobile embossing element (8), by the action of a force on a structured stamp (1), embosses the micro- and/or nanostructures (31) in the embossing material (6, 6'), **characterised in that** a removal of the structured stamp (1) from the embossing material (6, 6') is controlled in a targeted manner, wherein a clamping bar (4, 4') for fixing the structured stamp (1) can be moved along a removal curve, wherein the removal curve is in particular one of the following functions:
• polynomial, in particular
∘ straight-line,
∘ parabola
• root function
• logarithmic function
• trigonometric function, in particular
∘ sine function
• step function.

14. A stamp system (5), comprising a structured stamp (1), in particular a soft stamp, for embossing micro- and/or nanostructures (31) and a carrier (17), in particular of glass, connected to the structured stamp (1), in particular in a planar manner, wherein the structured stamp (1) and the carrier (17) are constituted elastically, in such a way that they can be deformed by an embossing element (8), wherein a clamping bar (4, 4') for fixing the structured stamp (1) can be moved along a removal curve, wherein the removal curve is in particular one of the following functions:
• polynomial, in particular
∘ straight-line,
∘ parabola
• root function
• logarithmic function
• trigonometric function, in particular
∘ sine function
• step function.

15. A removal means (19) for separating a structured stamp (1) from an embossing material (6, 6') for an apparatus (24, 24') according to any one of the preceding claims, wherein the removal means (19) are constituted for bringing about a linear movement, preferably directed normal to an embossing surface (60), of a side of the structured stamp (1).

16. An embossing element suspension system (21, 21', 21", 21"') for suspending an embossing element (8) of an apparatus (24, 24') according to any one of the preceding claims, which is constituted such that a force (F, F') acting on a structured stamp (1) and/or a carrier (17) of the structured stamp (1) can be adjusted by a counterforce (F_{A}, F_{A}') in a targeted manner.

## Revendications

1. Installation (24, 24') pour le marquage de micro- et/ou nanostructures (31) dans un matériau de marquage (6, 6') présentant un poinçon de structure (1) et un élément de marquage mobile (8), **caractérisé en ce qu'**un démoulage du poinçon de structure (1) du matériau de marquage (6, 6') peut être commandé de manière ciblée, dans laquelle une barre de serrage (4, 4') pour la fixation du poinçon de structure (1) est mobile le long d'une courbe de démoulage, dans laquelle pour la courbe de démoulage, il s'agit en particulier d'une des fonctions suivantes :
- polynôme, en particulier
- droite
- parabole
- fonction racine
- fonction logarithme
- fonction trigonométrique, en particulier
- fonction sinus
- fonction discontinue.

2. Installation (24, 24') selon la revendication 1, dans laquelle l'installation (24, 24') est conçue pour le fonctionnement step-and-repeat.

3. Installation (24, 24') selon l'une des revendications précédentes, présentant des moyens de démoulage (19) pour séparer le poinçon de structure (1) du matériau de marquage (6, 6').

4. Installation (24, 24') selon la revendication 3, dans laquelle les moyens de démoulage (19) sont conçus pour produire un mouvement linéaire, de préférence dirigé normalement sur une surface de marquage (60), d'un côté du poinçon de structure (1).

5. Installation (24, 24') selon la revendication 3 ou 4, dans laquelle les moyens de démoulage (19) présentent des tiges, de préférence des éléments linéaires placés.

6. Installation (24, 24') selon l'une des revendications 3, 4 ou 5, dans laquelle les moyens de démoulage (19) sont reliés au poinçon de structure (1), en particulier sur une barre de serrage (4, 4') qui tient le poinçon de structure (1) et/ou un support (17) avec le poinçon de structure (1).

7. Installation (24, 24') selon l'une des revendications précédentes, présentant un système de suspension d'élément de marquage (21, 21', 21", 21"') qui est conçu de façon à ce qu'une force (F, F') agissant sur le poinçon de structure (1) et/ou un support (17) du poinçon de structure (1) puisse être réglée de manière ciblée par une contre-force (F_{A}, F_{A}').

8. Installation (24, 24') selon la revendication 7, dans laquelle le système de suspension d'élément de marquage (21, 21', 21", 21'") est conçu en tant que bascule (21) et/ou support (21') et/ou en tant que spirale (21") disposé(e) rotatif/rotative.

9. Installation (24, 24') selon l'une des revendications précédentes, dans laquelle le poinçon de structure (1) est fixé, en particulier latéralement, par au moins une barre de serrage (4, 4'), dans laquelle l'au moins une barre de serrage (4, 4') est mobile, verticalement à une surface de marquage (60) et/ou dans un sens Z, en particulier par un système de levage (32).

10. Installation (24, 24') selon l'une des revendications précédentes, dans laquelle la barre de serrage (4, 4') est disposée rotative, en particulier rotative sur un axe de rotation qui est disposé parallèle à la surface de marquage (60) et/ou verticalement au sens Z et/ou verticalement au sens de déplacement de l'élément de marquage (8) et/ou parallèlement au sens Y.

11. Installation (24, 24') selon l'une des revendications précédentes, dans laquelle l'au moins une barre de serrage (4, 4'), en particulier le système de levage (32), est mobile, en particulier simultanément, dans un second sens, en particulier dans le sens X et/ou parallèlement à la surface de marquage (60) et/ou parallèlement au sens de déplacement de l'élément de marquage (8).

12. Installation (24, 24') selon l'une des revendications 3, 4, 5 ou 6, dans laquelle la vitesse de translation des moyens de démoulage (19) est entre 0,1 mm/s et 100 mm/s, de préférence entre 1 mm/s et 75 mm/s, plus encore de préférence entre 5 mm/s et 50 mm/s.

13. Procédé pour le marquage de micro- et/ou nanostructures (31) dans un matériau de marquage (6, 6'), dans lequel un élément de marquage mobile (8) marque les micro- et/ou nanostructures (31) dans le matériau de marquage (6, 6') par application de force sur un poinçon de structure (1), **caractérisé en ce qu'**un démoulage du poinçon de structure (1) du matériau de marquage (6, 6') peut être commandé de manière ciblée, dans laquelle une barre de serrage (4, 4') pour la fixation du poinçon de structure (1) est mobile le long d'une courbe de démoulage, dans laquelle pour la courbe de démoulage, il s'agit en particulier d'une des fonctions suivantes :
- polynôme, en particulier
- droite
- parabole
- fonction racine
- fonction logarithme
- fonction trigonométrique, en particulier
- fonction sinus
- fonction discontinue.

14. Système de poinçon (5), présentant un poinçon de structure (1), en particulier un poinçon souple, pour le marquage de micro- et/ou nanostructures (31) et un support (17), en particulier en verre, relié au poinçon de structure (1), en particulier en s'étendant en surface, dans lequel le poinçon de structure (1) et le support (17) sont conçus élastiques de façon à ce qu'ils puissent être déformés par un élément de marquage (8), dans lequel une barre de serrage (4, 4') pour la fixation du poinçon de structure (1) est mobile le long d'une courbe de démoulage, dans laquelle pour la courbe de démoulage, il s'agit en particulier d'une des fonctions suivantes :
- polynôme, en particulier
- droite
- parabole
- fonction racine
- fonction logarithme
- fonction trigonométrique, en particulier
- fonction sinus
- fonction discontinue.

15. Moyens de démoulage (19) pour séparer un poinçon de structure (1) d'un matériau de marquage (6, 6') pour une installation (24, 24') selon l'une des revendications précédentes, dans lequel les moyens de démoulage (19) sont conçus pour produire un mouvement linéaire, de préférence dirigé normalement sur une surface de marquage (60), d'un côté du poinçon de structure (1).

16. Système de suspension d'élément de marquage (21, 21', 21", 21'") pour suspendre un élément de marquage (8) d'une installation (24, 24') selon l'une des revendications précédentes, conçu de façon à ce qu'une force (F, F') agissant sur un poinçon de structure (1) et/ou un support (17) du poinçon de structure (1) puisse être réglée de manière ciblée par une contre-force (F_{A}, F_{A}').
